# EUROPEAN PATENT APPLICATION

(11) **EP 4 791 123 A1**
(43) Date of publication of application: **12.08.2026**
(21) Application number: 24883945.8
(22) Date of filing: 18.06.2024
(51) Int. Cl.: H05K 1/18, H01L 23/498

(54) **EMBEDDED SUBSTRATE, POWER SUPPLY APPARATUS, AND ELECTRONIC DEVICE**

(30) Priority: 01.11.2023 CN 202311450995
(71) Applicant: HUAWEI TECHNOLOGIES CO., LTD., Shenzhen 518129 (CN)
(72) Inventor: HAN, Jianhua, Shenzhen, Guangdong 518129 (CN); XIE, Ertang, Shenzhen, Guangdong 518129 (CN); GAO, Feng, Shenzhen, Guangdong 518129 (CN); XIE, Zhenlin, Shenzhen, Guangdong 518129 (CN); BAO, Kuanming, Shenzhen, Guangdong 518129 (CN); XU, Xiaofeng, Shenzhen, Guangdong 518129 (CN)
(74) Representative: MERH-IP Matias Erny Reichl Hoffmann Patentanwälte PartG mbB
(86) International application number: PCT/CN2024/099951
(87) International publication number: WO 2025/091934

(57) **Abstract**

An embedded substrate, a power supply apparatus, and an electronic device are disclosed. The embedded substrate includes a first front-side build-up layer bonded to a first surface of a core container. A conduction structure electrically connected to a line layer of the first front-side build-up layer is disposed in a dielectric layer of the first front-side build-up layer. The conduction structure includes a first conduction structure electrically connected to a pad of a chip. The dielectric layer of the first front-side build-up layer is made of an exposable and developable material, and a hole for constructing the conduction structure is formed through exposure and development. An opening of an outer protective layer has a first projection on the first surface, a first hole for constructing the first conduction structure has a second projection on the first surface, and the second projection covers the first projection. In this arrangement, the first conduction structure with a large through-current cross section is constructed based on an opening size on the chip side, to effectively improve a through-current capability and achieve high thermal conductivity. In addition, bonding stress between the line layer and a front side of the chip can be reduced, to reduce a risk of delamination and achieve high reliability.

## Description

This application claims priority to Chinese Patent Application No. 202311450995.7, filed with the China National Intellectual Property Administration on November 1, 2023 and entitled "EMBEDDED SUBSTRATE, POWER SUPPLY APPARATUS, AND ELECTRONIC DEVICE", which is incorporated herein by reference in its entirety.

### TECHNICAL FIELD

Embodiments of this application relate to the field of electronic component packaging technologies, and in particular, to an embedded substrate, a power supply apparatus, and an electronic device.

### BACKGROUND

In an embedded substrate technology, electronic components, for example, but not limited to, a chip, a resistor, a capacitor, and an inductor, may be embedded in a substrate, and interconnected through peripheral lines, to form a highly integrated high-density functional module. The embedded substrate technology may be used in various different application scenarios. With continuous evolution of product functions, achieving a large current, high heat dissipation, and high reliability has become a core requirement for an embedded substrate.

In a typical power chip package module, components, for example, a chip, are embedded in a core PCB structure, and a build-up layer is stacked on a surface of the core PCB, to implement a highly integrated circuit for interconnection. Usually, a pad on a front side of the chip is exposed from an opening of a PI layer (an outer protective layer), and a blind via is formed, through a laser (Laser) process, on the build-up layer adjacent to the chip, to establish an electrical connection between the chip side and the build-up layer side. However, due to limited arrangement position precision of the chip and processing position precision of the blind via, an annular ring width needs to be reserved between the blind via and the opening of the PI layer, and a diameter of the blind via is less than a size of the opening of the PI layer of the chip. A size of an opening of an incoming material of the chip is fixed. Consequently, a through-current capability and thermal conductivity of the blind via are limited by a design bottleneck, directly affecting a through-current capability and thermal conductivity on the front side of the chip.

### SUMMARY

Embodiments of this application provide an embedded substrate, a power supply apparatus, and an electronic device, to achieve a large current, high heat dissipation, and high reliability by optimizing a structure of an embedded substrate.

A first aspect of embodiments of this application provides an embedded substrate. The embedded substrate includes a core container, a build-up layer, and a chip embedded in the core container. The core container includes a first surface and a second surface, and a front side of the chip faces the first surface of the core container. An outer protective layer is disposed on an outer side of a pad of the chip, and the outer protective layer has an opening corresponding to the pad of the chip. The build-up layer includes a front-side build-up layer covering the first surface of the core container. The front-side build-up layer includes a first front-side build-up layer bonded to the first surface of the core container and the front side of the chip. The first front-side build-up layer includes a dielectric layer and a line layer that are stacked, and a conduction structure electrically connected to the line layer of the first front-side build-up layer is disposed in the dielectric layer of the first front-side build-up layer. The conduction structure includes a first conduction structure electrically connected to the pad of the chip. The dielectric layer of the first front-side build-up layer is made of an exposable and developable material, and a hole for constructing the conduction structure is formed through exposure and development. A hole for constructing the first conduction structure is a first hole. The opening of the outer protective layer has a first projection on the first surface, the first hole corresponding to the opening has a second projection on the first surface, and the second projection covers the first projection.

In this arrangement, the first conduction structure can be constructed based on an opening size on the chip side to a maximum extent, and the first conduction structure has a large through-current cross section, to effectively improve a through-current capability and achieve high thermal conductivity. In addition, the first hole of the first conduction structure is formed through an exposure and development process, to avoid difficulty in a conventional process of forming a hole through laser, and achieve high processability.

In addition, in comparison with an implementation solution in which a copper layer is plated on the outer protective layer on the front side of the chip to improve thermal conductivity of the substrate, in embodiments of this application, both the dielectric layer of the first front-side build-up layer and the outer protective layer on the chip side are made of organic materials, and the dielectric layer of the first front-side build-up layer can reduce bonding stress between the line layer and the front side of the chip, to reduce a risk of delamination between inter-layer interfaces. Overall reliability is high.

For example, the exposable and developable material may be dry film, and may be formed through press-fitting. For another example, the exposable and developable material may alternatively be liquid photoresist, and may be applied to the core container through coating or spin coating.

Based on the first aspect, embodiments of this application further provide a first implementation of the first aspect: The embedded substrate further includes an electronic component embedded in the core container, the conduction structure further includes a second conduction structure electrically connected to a pin of the electronic component, and a hole for constructing the second conduction structure is a second hole. In this way, configuration can be flexibly performed according to a requirement for a product function.

During actual application, a plurality of electronic components are disposed, and at least one of the plurality of electronic components is a capacitor or a resistor.

Based on the first aspect or the first implementation of the first aspect, embodiments of this application further provide a second implementation of the first aspect: The embedded substrate further includes a through-current structure disposed in the core container, the conduction structure further includes a third conduction structure electrically connected to the through-current structure, and a hole for constructing the third conduction structure is a third hole. In this way, for an external connection relationship on the first surface side of the core container, a hole may be formed through an exposure and development process, so that overall processability is high.

Based on the first aspect, the first implementation of the first aspect, or the second implementation of the first aspect, embodiments of this application further provide a third implementation of the first aspect: The core container is a core PCB made of an organic material.

For example, a base of the core PCB may be made of the following organic material: glass cloth reinforced epoxy phenolic resin (Flame Resistant 4, FR4), bismaleimide triazine resin (Bismaleimide Triazine resins, BT), BT-like resin, or the like.

Based on the third implementation of the first aspect, embodiments of this application further provide a fourth implementation of the first aspect: The through-current structure in the core PCB is a plated through hole (Plated Through Hole, PTH) or a copper pillar that passes through a core PCB base, or the through-current structure in the core PCB is a hierarchical hole structure in the core PCB base.

During actual application, the PTH through hole has a flat opening, high processability, and controllable costs. In this way, stacking and reliable connection of blind vias can be implemented based on the PTH through hole, to facilitate fast transmission of a signal, heat, and a current.

Based on the first aspect, the first implementation of the first aspect, or the second implementation of the first aspect, embodiments of this application further provide a fifth implementation of the first aspect: The core container is a core PCB made of a glass material. In this way, overall strength of the substrate is improved based on the glass substrate framework. In addition, based on adjustability of a coefficient of thermal expansion (coefficient of thermal expansion, CTE) of the glass material, in a specific implementation, glass whose CTE is close to a CTE of a base material of the chip may be selected, to effectively reduce structural stress.

Based on the fifth implementation of the first aspect, embodiments of this application further provide a sixth implementation of the first aspect: The through-current structure in the core PCB is a TGV. Herein, thermal conductivity and a through-current capability can be further improved based on high hole density and a good hole filling capability of the through glass via (through Glass vias, TGV).

Based on the third implementation of the first aspect, the fourth implementation of the first aspect, the fifth implementation of the first aspect, or the sixth implementation of the first aspect, embodiments of this application further provide a seventh implementation of the first aspect: The chip and the electronic component embedded in the core PCB are aligned with a first surface of the core PCB, or are aligned with a second surface of the core PCB. In a specific implementation, a case in which the chip and the electronic component embedded in the core PCB are aligned with the first surface of the core PCB facilitates specific implementation of an exposure and development process for forming a hole, and a case in which the chip and the electronic component embedded in the core PCB are aligned with the second surface of the core PCB facilitates high thermal conductivity of a product architecture without a rear-side build-up layer.

Based on the third implementation of the first aspect, the fourth implementation of the first aspect, the fifth implementation of the first aspect, the sixth implementation of the first aspect, or the seventh implementation of the first aspect, embodiments of this application further provide an eighth implementation of the first aspect: An embedded material at a periphery of the chip and the electronic component is an Ajinomoto build-up film (Ajinomoto Build-up Film, ABF) dielectric material that is characterized by controllable costs. Alternatively, an embedded material at a periphery of the chip and the electronic component is an exposable and developable material that helps achieve higher overall processability.

Based on the first aspect, the first implementation of the first aspect, the second implementation of the first aspect, the third implementation of the first aspect, the fourth implementation of the first aspect, the fifth implementation of the first aspect, the sixth implementation of the first aspect, the seventh implementation of the first aspect, or the eighth implementation of the first aspect, embodiments of this application further provide a ninth implementation of the first aspect: The build-up layer further includes a rear-side build-up layer covering the second surface of the core container. In this way, a through-current path and a heat conduction path between the embedded substrate and the outside can be flexibly arranged.

Based on the ninth implementation of the first aspect, embodiments of this application further provide a tenth implementation of the first aspect: A heat conduction portion is disposed in the rear-side build-up layer, an inner end side of the heat conduction portion abuts against a rear side of the chip, and an outer end side of the heat conduction portion extends to a surface layer of the rear-side build-up layer. In this way, the heat conduction portion can effectively reduce thermal resistance on the rear side of the chip, to quickly dissipate heat generated by the chip, and achieve high thermal conductivity.

For example, the heat conduction portion may be a copper block, or may be blind vias or copper strips that are arranged in an array.

During actual application, the rear side of the chip may have a rear copper layer, so that the inner end side of the heat conduction portion abuts against the rear copper layer. The rear copper layer can provide a good heat equalization capability, to further improve thermal conductivity on the rear side, and reduce operating temperature of the chip. For example, when the embedded substrate is used in a power module, power efficiency can be improved.

Based on the ninth implementation of the first aspect or the tenth implementation of the first aspect, embodiments of this application further provide an eleventh implementation of the first aspect: The rear-side build-up layer includes a first rear-side build-up layer. The first rear-side build-up layer is bonded to the second surface of the core container. The first rear-side build-up layer includes a dielectric layer and a line layer that are stacked. A conduction structure electrically connected to the line layer of the first rear-side build-up layer is disposed in the dielectric layer of the first rear-side build-up layer.

During actual application, the dielectric layer of the first rear-side build-up layer may alternatively be made of an exposable and developable material, and a hole for constructing the conduction structure is formed through exposure and development. For a fabrication process of the embedded substrate, a process route can be simplified.

Based on the eleventh implementation of the first aspect, embodiments of this application further provide a twelfth implementation of the first aspect: The dielectric layer of the first rear-side build-up layer is made of prepreg (Prepreg, PP). In this arrangement, the PP material has good strength and high-temperature resistance performance, so that overall strength of the substrate is enhanced. In addition, the inner end side of the heat conduction portion abuts against the chip, and the outer end side of the heat conduction portion extends to the surface layer of the rear-side build-up layer. To be specific, in an example in which the embedded material is the ABF, the heat conduction portion sequentially passes through an ABF filling layer and the PP build-up layer, to achieve pinning effect at a joint interface between the ABF filling layer and the PP build-up layer, to reduce a risk of delamination between the ABF embedded material and the PP build-up layer material, and further improve reliability.

Based on the eleventh implementation of the first aspect or the twelfth implementation of the first aspect, embodiments of this application further provide a thirteenth implementation of the first aspect: The rear-side build-up layer includes at least one second rear-side build-up layer, the second rear-side build-up layer is stacked on the first rear-side build-up layer, the second rear-side build-up layer includes a dielectric layer and a line layer that are stacked, and the dielectric layer of the second rear-side build-up layer is made of ABF, PP, or an exposable and developable material.

Based on the first aspect, the first implementation of the first aspect, the second implementation of the first aspect, the third implementation of the first aspect, the fourth implementation of the first aspect, the fifth implementation of the first aspect, the sixth implementation of the first aspect, the seventh implementation of the first aspect, the eighth implementation of the first aspect, the ninth implementation of the first aspect, the tenth implementation of the first aspect, the eleventh implementation of the first aspect, the twelfth implementation of the first aspect, or the thirteenth implementation of the first aspect, embodiments of this application further provide a fourteenth implementation of the first aspect: The front-side build-up layer includes at least one second front-side build-up layer, the second front-side build-up layer is sequentially stacked on the first front-side build-up layer, the second front-side build-up layer includes a dielectric layer and a line layer that are stacked, and the dielectric layer of the second front-side build-up layer is made of ABF, PP, or an exposable and developable material.

Based on the first aspect, the first implementation of the first aspect, or the second implementation of the first aspect, embodiments of this application further provide a fifteenth implementation of the first aspect: The core container is a dielectric filling layer made of a dielectric filling material. In this arrangement, a process is simple, and manufacturing costs can be properly controlled.

For example, the dielectric filling material may be an exposable and developable material. In this way, during formation of the core container, the dielectric layer of the first front-side build-up layer can be synchronously formed, to achieve high processability.

During actual application, a through-current structure in the dielectric filling layer may be a copper pillar, to achieve high thermal conductivity and a good through-current capability.

Based on the fifteenth implementation of the first aspect, embodiments of this application further provide a sixteenth implementation of the first aspect: The chip and the electronic component embedded in the core PCB are aligned with a second surface of the dielectric filling layer.

A second aspect of embodiments of this application provides a power supply apparatus. The power supply apparatus includes a chip, an inductor, and a plurality of electronic components. The chip and a part of the plurality of electronic components form a first package body by using the foregoing embedded substrate, the inductor and another part of the plurality of electronic components form a second package body, and the second package body and the first package body are stacked.

A third aspect of embodiments of this application provides an electronic device. The electronic device includes a system board and a power supply apparatus. The power supply apparatus is disposed on the system board, and the power supply apparatus is the foregoing power supply apparatus.

A fourth aspect of embodiments of this application provides an electronic device. The electronic device includes a main board and an embedded component. The embedded component is disposed on the main board, and the embedded component is prepared by using the foregoing embedded substrate.

During actual application, the electronic device may be a server, a computer, a high-performance computing cluster, or a high-power, high-integration, and ultra-large-scale data center server, or the electronic device may be a switch, a router, an edge device, or the like.

### BRIEF DESCRIPTION OF DRAWINGS

FIG. 1 is a cross-sectional view of an architecture of an embedded substrate according to an embodiment of this application;
FIG. 2 is a diagram of a relationship between a projection of a first hole and a corresponding opening shown in FIG. 1;
FIG. 3 is a diagram of a fabrication process of an embedded substrate shown in FIG. 1;
FIG. 4 is a cross-sectional view of an architecture of another embedded substrate according to an embodiment of this application;
FIG. 5 is a layout diagram of an arrayed heat conduction structure according to an embodiment of this application;
FIG. 6 is a layout diagram of an arrayed heat conduction structure according to an embodiment of this application;
FIG. 7 is a diagram of a fabrication process of an embedded substrate shown in FIG. 4;
FIG. 8 is a cross-sectional view of an architecture of still another embedded substrate according to an embodiment of this application;
FIG. 9 is a diagram of a fabrication process of an embedded substrate shown in FIG. 8;
FIG. 10 is a cross-sectional view of an architecture of still another embedded substrate according to an embodiment of this application;
FIG. 11 is a diagram of a fabrication process of an embedded substrate shown in FIG. 10;
FIG. 12 is a cross-sectional view of an architecture of another embedded substrate according to an embodiment of this application;
FIG. 13 is a diagram of a fabrication process of an embedded substrate shown in FIG. 12;
FIG. 14 is a cross-sectional view of an architecture of still another embedded substrate according to an embodiment of this application;
FIG. 15 is a diagram of a fabrication process of an embedded substrate shown in FIG. 14;
FIG. 16 is a cross-sectional view of an architecture of another embedded substrate according to an embodiment of this application;
FIG. 17 is a diagram of a fabrication process of an embedded substrate shown in FIG. 16;
FIG. 18 is a cross-sectional view of an architecture of still another embedded substrate according to an embodiment of this application;
FIG. 19 is a diagram of a fabrication process of an embedded substrate shown in FIG. 18;
FIG. 20 is a cross-sectional view of an architecture of another embedded substrate according to an embodiment of this application;
FIG. 21 is a diagram of a fabrication process of an embedded substrate shown in FIG. 20;
FIG. 22 is a cross-sectional view of an architecture of still another embedded substrate according to an embodiment of this application;
FIG. 23 is a diagram of a fabrication process of an embedded substrate shown in FIG. 22;
FIG. 24 is a cross-sectional view of an architecture of still another embedded substrate according to an embodiment of this application;
FIG. 25 is a diagram of a fabrication process of an embedded substrate shown in FIG. 24;
FIG. 26 is a cross-sectional view of an architecture of still another embedded substrate according to an embodiment of this application;
FIG. 27 is a diagram of a fabrication process of an embedded substrate shown in FIG. 26;
FIG. 28 is a diagram of an application scenario of a power module according to an embodiment of this application;
FIG. 29 is a diagram of an application scenario of another power module according to an embodiment of this application; and
FIG. 30 is a diagram of an electronic setting according to an embodiment of this application.

### DESCRIPTION OF EMBODIMENTS

Embodiments of this application provide an implementation solution of an embedded substrate capable of achieving a large current, high heat dissipation, and high reliability, to adapt to different high-integration and high-density application scenarios.

An embedded substrate technology is used to embed an electronic component into a substrate, to shorten a link path between components, reduce transmission loss, improve product integration, and reduce an outline size of a module. The embedded substrate technology may be used in various different application scenarios. With continuous evolution of product functions, achieving a large current, high heat dissipation, and high reliability has become a core requirement for an embedded substrate.

An embedded substrate used in a power chip package module is used as an example. In a typical embedded substrate architecture, a chip and components such as a capacitor and/or a resistor may be embedded in a core PCB, and a build-up layer is stacked on a surface of the core PCB, to implement interconnection between components and a connection to an external circuit. Usually, a pad on a front side (a solder side) of the chip is exposed from an opening of a PI layer (an outer protective layer). Correspondingly, a hole is formed on the build-up layer through a laser process, and a blind via corresponding to the pad is formed, to establish an electrical connection between the chip side and the build-up layer side. Usually, an annular ring width needs to be reserved between the blind via and the opening of the PI layer, and an opening size of an incoming material of the chip is fixed. Therefore, a diameter of the formed blind via is less than a size of the opening of the PI layer of the chip, leading to a limitation on improvement of a through-current capability and thermal conductivity of the blind via.

In view of this, embodiments of this application provide an embedded substrate. The embedded substrate includes a core container, a build-up layer, and a chip embedded in the core container. The core container includes a first surface and a second surface, and a front side of the chip faces the first surface of the core container. The front side of the chip includes an outer protective layer located on an outer side of a pad of the chip, and the outer protective layer has an opening corresponding to the pad of the chip. The build-up layer includes a front-side build-up layer covering the first surface of the core container. The front-side build-up layer includes a first front-side build-up layer bonded to the first surface of the core container, and the first front-side build-up layer is bonded to the front side of the chip. The first front-side build-up layer includes a dielectric layer and a line layer that are stacked. A first conduction structure electrically connected to the line layer is disposed in the dielectric layer, and the first conduction structure corresponds to and is electrically connected to the pad of the chip. In embodiments of this application, the dielectric layer of the first front-side build-up layer is made of an exposable and developable material, a first hole for constructing the first conduction structure is formed through exposure and development, an opening of an outer protective layer has a first projection on the first surface, the first hole corresponding to the opening has a second projection on the first surface, and the second projection covers the first projection. In this way, the first hole with a large size can be formed through an exposure and development process, and a size of the first hole is greater than a size of the opening of the outer protective layer of the chip, so that the opening on the chip side can be fully utilized to form the first conduction structure used for current conduction. The first conduction structure may be, for example, but not limited to, a blind via formed through a chemical copper plating or electroplating process. In this arrangement, the first conduction structure can be constructed based on an opening size on the chip side to a maximum extent, and the first conduction structure has a large through-current cross section, to effectively improve a through-current capability and achieve high thermal conductivity. In addition, the first hole of the first conduction structure is formed through an exposure and development process, to avoid difficulty in a conventional process of forming a hole through laser, and achieve high processability.

In addition, in comparison with an implementation solution in which a copper layer is plated on the outer protective layer (a PI layer) on the front side of the chip to improve thermal conductivity of the substrate, in embodiments of this application, both the dielectric layer of the first front-side build-up layer and the outer protective layer on the chip side are made of organic materials, and the dielectric layer of the first front-side build-up layer can reduce bonding stress between the line layer and the front side of the chip, to reduce a risk of delamination between inter-layer interfaces. Overall reliability is high.

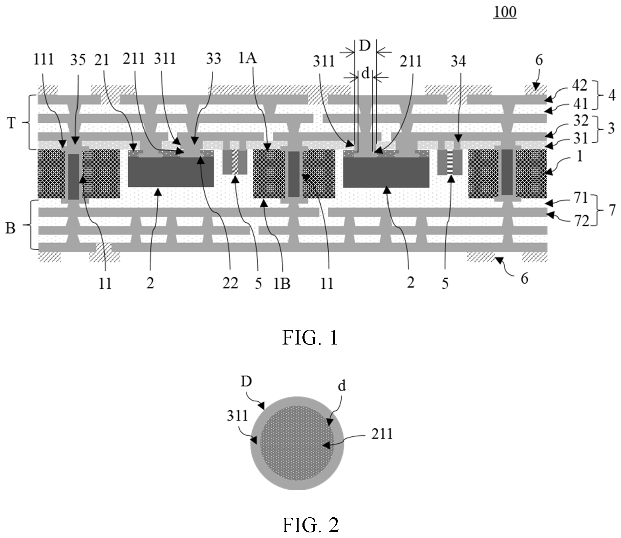

To better understand the technical solutions and technical effects of this application, the following describes specific embodiments in detail with reference to the accompanying drawings, without loss of generality. FIG. 1 is a cross-sectional view of an architecture of an embedded substrate according to an embodiment of this application.

As shown in FIG. 1, in the embedded substrate 100, a core PCB 1 serves as a core container, and a chip 2 and an electronic component 5 are embedded in the core PCB 1. To clearly show a basic architecture relationship of the embedded substrate, for example, two chips 2 and two electronic components 5 are used as an example in the figure. In a specific implementation, quantities of disposed chips 2 and electronic components 5 may be determined according to an overall product design requirement. In addition, when a plurality of electronic components 5 are disposed, at least one electronic component 5 is a capacitive component or a resistive component. This is not limited in this embodiment of this application.

In a specific implementation, a base of the core PCB 1 may be made of an organic material, for example, but not limited to, an FR4, BT, or BT-like material. Components, such as the chip 2 and the electronic component 5, that are disposed in an embedded slot on the core PCB 1 may be assembled and fastened through filling by using ABF.

In this implementation solution, a front side of the chip 2 faces a first surface 1A of the core PCB 1, an outer protective layer on the front side of the chip 2 is a PI layer 21, and the PI layer 21 is aligned with the first surface 1A of the core PCB 1. The "being aligned" herein includes a case in which the first surface 1A of the core PCB 1 is completely flush with a surface of the PI layer 21, and further includes a case in which the first surface 1A of the core PCB 1 is approximately flush with the surface of the PI layer 21 within an allowed tolerance range. Correspondingly, a rear side of the chip 2 faces the first surface 1A of the core PCB 1. An opening 211 is provided on the PI layer 21, the opening 211 corresponds to a pad 22 located at an inner layer, and the pad 22 is exposed from the corresponding opening 211, to implement an electrical connection to an external circuit.

In another possible implementation solution, the outer protective layer may alternatively be made of another organic material, provided that physical isolation can be provided to avoid oxidation of a chip base, and a function requirement for external electrical connection performance of the chip is met. Details are not described in this embodiment of this application.

Both sides of the core PCB 1 of the embedded substrate 100 each are covered with a build-up layer, and a circuit layer of the build-up layer is connected to a component embedded in the core PCB 1, to implement a more complex circuit connection and function. In this implementation solution, the first surface 1A of the core PCB 1 is covered with a front-side build-up layer T, and a second surface 1B of the core PCB 1 is covered with a rear-side build-up layer B, to implement double-side interconnection and heat dissipation.

As shown in FIG. 1, the front-side build-up layer T includes three sequentially stacked layers: one first front-side build-up layer 3 and two second front-side build-up layers 4. The first front-side build-up layer 3 is located at an inner layer of the front-side build-up layer T, and is bonded to the core PCB 1 and the PI layer 21 on the front side of the chip 2. Compared with the first front-side build-up layer 3, the second front-side build-up layer 4 is located at an outer layer of the front-side build-up layer T. In a specific implementation, a quantity second front-side build-up layers 4 may be set according to a requirement, and is not limited to the two layers shown in the figure.

Each build-up layer includes a dielectric layer and a line layer that are stacked. A line layer 32 of the first front-side build-up layer 3 is stacked on a dielectric layer 31, and a line layer 42 of the second front-side build-up layer 4 is stacked on a dielectric layer 41.

The dielectric layer 31 of the first front-side build-up layer 3 is made of an exposable and developable material, and the dielectric layer 41 of the second front-side build-up layer 4 may be made of ABF or PP.

In a specific implementation, the exposable and developable material may be dry film (Dry Film), and may be specifically selected based on an overall design of the architecture of the embedded substrate. Based on exposable and developable characteristics of the material, a corresponding hole may be formed on the dielectric layer 31, to form a conduction structure capable of implementing a corresponding connection function. In other words, a hole for constructing the conduction structure may be formed on the dielectric layer 31 of the first front-side build-up layer 3 through an exposure and development process. Herein, an arrangement position of the conduction structure is determined according to a requirement for an electrical connection between the build-up layer side and the core PCB 1 side, to implement an electrical connection and conduction to a corresponding component or circuit.

In another possible implementation solution, the exposable and developable material may alternatively be liquid photoresist (Liquid Photoresist), and may be specifically applied to the core PCB 1 through coating or spin coating.

In this implementation solution, for the chip 2 embedded in the core PCB 1, the pad 22 of the chip 2 is connected to the line layer 32 of the front-side build-up layer T through a first conduction structure 33. A pin side of the electronic component 5 is also aligned with the first surface 1A of the core PCB 1. For the electronic component 5 embedded in the core PCB 1, the pin of the electronic component 5 may be connected to the line layer 32 of the front-side build-up layer T through a second conduction structure 34. Another interface on the first surface of the core PCB 1, for example, but not limited to, an interface pad 111 shown in the figure, may be connected to the line layer 32 of the front-side build-up layer T through a third conduction structure 35. It can be understood that, for conduction structures with various configuration functions, corresponding holes may be respectively formed at positions of the conduction structures through exposure and development processes. In a specific implementation, the hole may be a blind via or a copper pillar. In this implementation solution, a conduction structure in a form of a blind via is specifically used as an example for description.

On the dielectric layer 31 of the first front-side build-up layer 3, a hole for constructing the first conduction structure 33 is a first hole 311, and a second projection of the first hole 311 on the first surface 1A covers a first projection of the corresponding opening 211 of the PI layer 21 on the first surface 1A.

The "first surface" herein is a reference plane for indicating a comparison relationship between a size of the first hole and a size of the corresponding opening, and the reference plane may alternatively be another reference plane parallel to the first surface. It should be understood that the first surface serving as the reference plane does not constitute a substantive limitation on the core PCB described in this implementation.

The "covering" herein includes a case in which an external contour d of the first projection of the opening 211 on the first surface 1A is completely within an external contour D of the second projection of the first hole 311 on the first surface 1A, and further includes a case in which the external contour d of the first projection of the opening 211 on the first surface 1A partially overlaps with the external contour D of the second projection of the first hole 311 on the first surface 1A, for example, but not limited to, the following cases: The external contours of the two projections have a local overlapping point, or the external contours of the two projections have a local overlapping line segment.

FIG. 2 is a diagram of a relationship between a projection of the first hole 311 and a projection of the corresponding opening 211 of the PI layer. In FIG. 2, a first hole 311 and an opening 211 that are arranged in correspondence are used an example to show a relationship between a projection of the first hole 311 and a projection of the opening 211. For ease of description, cross sections of both the first hole 311 and the opening 211 shown in the figure are circular cross sections.

In a possible implementation solution, cross-sectional shapes of the first hole 311 and the opening 211 may be elliptic shapes, rectangular shapes, or other polygonal shapes, or may be set to irregular shapes based on actual spatial arrangement on a plate surface. This is not limited in this embodiment of this application.

In addition, as shown in FIG. 2, a center of a second projection of the first hole 311 overlaps with a center of a first projection of the opening 211. In another possible implementation solution, when the second projection of the first hole 311 on the dielectric layer 31 of the first front-side build-up layer 3 covers the first projection of the corresponding opening 211 on the PI layer 21, a relative positional relationship between the second projection of the first hole 311 and the first projection of the opening 211 on the reference plane may alternatively be non-center overlapping. This is not limited in this embodiment of this application.

Still as shown in FIG. 1, in this implementation solution, the rear-side build-up layer B includes three build-up layers, where a first rear-side build-up layer 7 is located at an inner layer of the rear-side build-up layer B and is bonded to the second surface of the core PCB 1, the other two build-up layers are sequentially stacked on the first rear-side build-up layer 7, and each build-up layer includes a dielectric layer and a line layer that are stacked. Herein, the dielectric layer of each build-up layer of the rear-side build-up layer B may be made of ABF. To be specific, the dielectric layer of each build-up layer of the rear-side build-up layer B may be made of a material the same as that of the second front-side build-up layer 4 on the front-side build-up layer T side.

In a specific implementation, specific quantities of disposed front-side build-up layers T and rear-side build-up layers B may be determined according to a product design requirement, and are not limited to the three layers shown in the figure.

In another possible implementation solution, the rear-side build-up layer B may be selectively disposed according to a requirement.

In this implementation solution, a PTH through hole 11 is provided on the base of the core PCB 1, to implement conduction between the first surface 1A and the second surface 1B of the core PCB 1, and provide functions of power supply, signal transmission, and heat conduction. The PTH through hole 11 may be formed through filling, polishing, and electroplating processes, and has a flat opening, high processability, and controllable costs. In this way, stacking and reliable connection of blind vias can be implemented based on the PTH through hole 11, to facilitate fast transmission of a signal, heat, and a current.

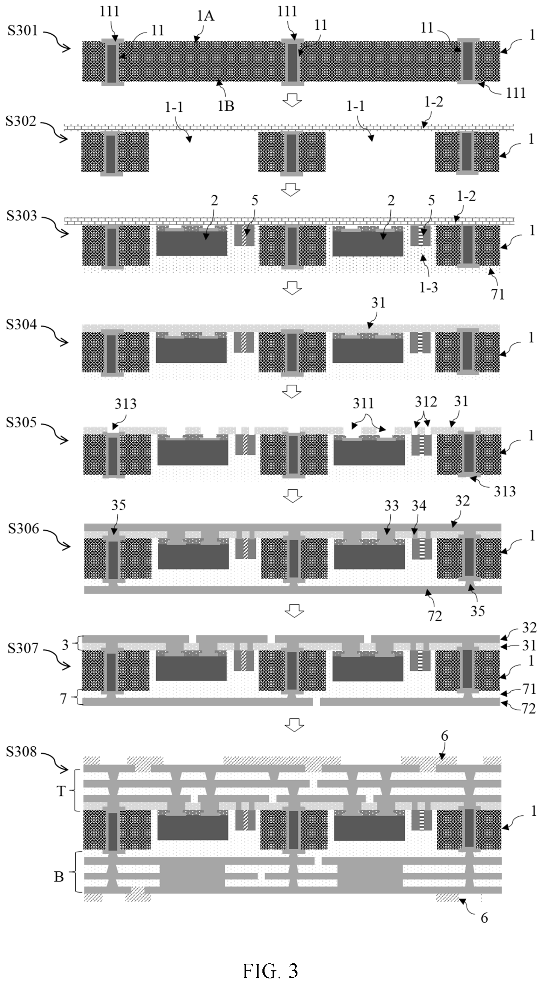

With reference to FIG. 3, the following briefly describes a fabrication process of the embedded substrate 100 described in FIG. 1.

Step S301: Prepare a core PCB 1.

First, after an organic incoming material of the core PCB arrives, a hole is prepared at a position at which a PTH through hole 11 is to be formed, and adhesive is removed. Then the PTH through hole 11 is electroplated based on a copper deposition process, and is filled and polished. In a specific implementation, the hole may be filled with resin or conductive copper paste. Then surface copper is electroplated after a seed layer is formed on a plate surface. In a specific implementation, the seed layer may be formed through a chemical copper plating process or a sputtering process. Finally, a surface copper layer is patterned to form an interface pad 111.

Step S302: Prepare for embedding and mounting.

An embedded slot 1-1 is provided on the core PCB 1, and adhesive is removed. In a specific implementation, the slot may be provided through a UV laser (ultraviolet laser), a CO2 laser (carbon dioxide laser), or another machining process. Then adhesive tape (tape) 1-2 is attached to a first surface 1A of the core PCB 1.

Step S303: Mount a chip and an electronic component, and perform press-fitting and filling.

Specifically, the chip 2 and the electronic component 5 are disposed in the embedded slot 1-1, with their front sides attached to the adhesive tape 1-2. Herein, the electronic component 5 may be a capacitor, a resistor, or an inductor. Then a filling and press-fitting operation is performed. An embedded filling material 1-3 may be ABF, or may be selected based on an actual process condition.

Herein, while press-fitting and filling gaps between components and between the components and the embedded slot, the embedded filling material 1-3 further forms a dielectric layer 71, bonded to a second surface 1B side of the core PCB 1, of a first rear-side build-up layer 7. The first rear-side build-up layer 7 herein is a build-up layer structure, bonded to the second surface of the core PCB 1, of a rear-side build-up layer B.

Step S304: Press-fit a dielectric layer 31 of a first front-side build-up layer 3.

The adhesive tape 1-2 is removed, an exposable and developable material is press-fitted on the core PCB 1 to form the dielectric layer 31, and the dielectric layer 31 is bonded to the front sides of the chip 2 and the electronic component 5.

Step S305: Form a hole on a front side through an exposure and development process, and form a hole on a rear side.

Specifically, on the dielectric layer 31 of the first front-side build-up layer 3, a first hole 311 is formed in correspondence to a pad 22 of the chip 2, a second hole 312 is formed in correspondence to a pin of the electronic component 5, and a third hole 313 is formed in correspondence to the interface pad 111 of the PTH through hole 11. In a specific implementation, after holes are formed, components are electrically connected to interfaces or pins and are exposed from corresponding holes, to construct conduction structures.

Based on a laser-based hole forming process, the third hole 313 is formed, in correspondence to the interface pad 111 of the PTH through hole 11, on the embedded filling material 1-3 layer on a rear side of the chip 2.

Step S306: Form conduction structures, surface copper of the first front-side build-up layer, and surface copper of the first rear-side build-up layer.

First, adhesive is removed. Then a seed layer may be first formed. In a specific implementation, the seed layer may be formed through a chemical copper plating or sputtering process. Then wall surfaces of the first hole 311, the second hole 312, and the third hole 313 are electroplated to form conductive blind vias, to form a first conduction structure 33, a second conduction structure 34, and a third conduction structure 35 respectively.

In addition, the front side and the rear side are electroplated to form surface copper, a surface copper layer on the front side is used to form a line layer 32 of the first front-side build-up layer, and a surface copper layer on the rear side is used to form a line layer 72 of the first rear-side build-up layer.

Step S307: Pattern the surface copper layer on the front side and the surface copper layer on the rear side.

After surface processing, film pressing, exposure, development, etching, and film stripping processes may be sequentially performed to form corresponding line layers, to complete preparation of the first front-side build-up layer 3 and the first rear-side build-up layer 7.

Step S308: Form outer layers of a front-side build-up layer T and the rear-side build-up layer B, form an outer solder mask layer 6, and process a surface of outer-layer metal.

In a specific implementation, a quantity of outer build-up layers may be determined according to an overall product design requirement, and a corresponding fabrication procedure is formulated. This is not limited in this embodiment of this application.

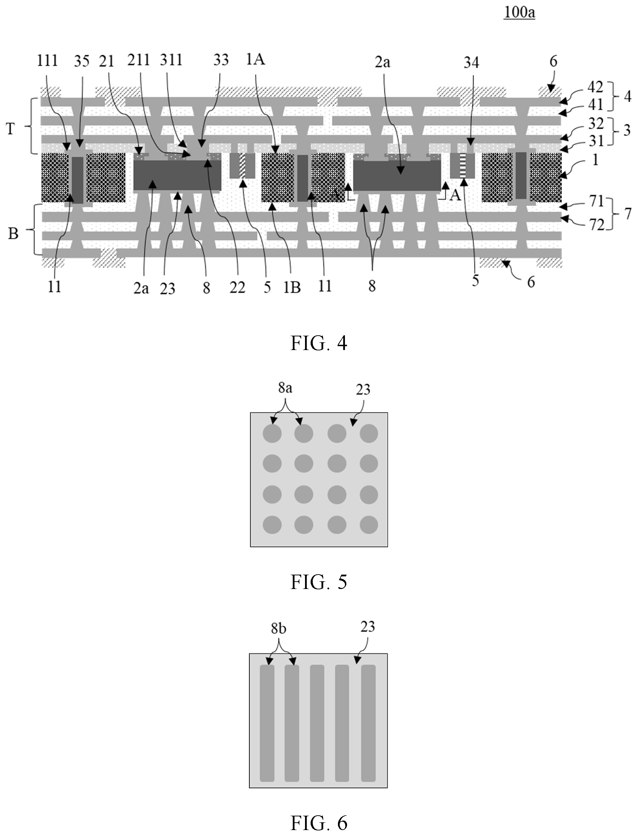

For a chip, to further improve thermal conductivity on a rear side of the chip, in another specific implementation, a corresponding heat conduction portion may be disposed on the rear side of the chip. FIG. 4 is a cross-sectional view of an architecture of another embedded substrate according to an embodiment of this application. To clearly show a difference and a relationship between this implementation solution and the embodiment described in FIG. 1, components or structures with a same function are indicated by a same reference sign in the figures.

As shown in FIG. 4, a chip 2a and an electronic component 5 are embedded in a core PCB 1 of the embedded substrate 100a, where a front side of the chip 2a faces a first surface 1A of the core PCB 1, and a PI layer 21 on the front side of the chip 2a is aligned with the first surface 1A of the core PCB 1. The first surface 1A of the core PCB 1 is covered with a front-side build-up layer T, and a second surface 1B of the core PCB 1 is covered with a rear-side build-up layer B.

A dielectric layer 31 of a first front-side build-up layer 3 is made of an exposable and developable material, and a dielectric layer 41 of a second front-side build-up layer 4 may be made of ABF. Similarly, dielectric layers of build-up layers of the rear-side build-up layer B may also be made of ABF.

A pad 22 of the chip 2a is connected to a line layer 32 of the front-side build-up layer T through a first conduction structure 33. On the dielectric layer 31 of the first front-side build-up layer 3, a hole for constructing the first conduction structure 33 is a first hole 311, and a second projection of the first hole 311 on the first surface 1A covers a first projection of a corresponding opening 211 of the PI layer 21 on the first surface 1A.

In this way, the first conduction structure 33 can be constructed based on a size of the first hole 311 on the chip 2a side to a maximum extent, and the first conduction structure 33 with a large through-current cross section has high thermal conductivity. In addition, because the dielectric layer 31 of the first front-side build-up layer 3 and the PI layer 21 on the chip 2a side are made of materials whose coefficients of thermal expansion tend to be close to each other, bonding stress between the line layer and the front side of the chip 2a can be reduced.

In this implementation solution, a pin of the electronic component 5 embedded in the core PCB 1 may be connected to the line layer 32 of the front-side build-up layer T through a second conduction structure 34. A PTH through hole 11 is provided on a base of the core PCB 1, and is connected to the line layer of the front-side build-up layer T and a line layer of the rear-side build-up layer B through pads at two ends of the PTH through hole 11 respectively.

As shown in the figure, a rear side of the chip 2a abuts against heat conduction structures 8 arranged in an array. In this implementation solution, an inner end side of each heat conduction structure 8 abuts against a rear copper layer 23 of the chip 2a, and an outer end side of each heat conduction structure 8 extends to a surface layer of the rear-side build-up layer B. In this way, a heat conduction portion formed by the arrayed heat conduction structures 8 can effectively reduce Z-direction thermal resistance on the rear side of the chip 2a, to quickly dissipate heat generated by the chip, and achieve high thermal conductivity.

In a specific implementation, the rear copper layer 23 of the chip 2a may be rear copper disposed upon delivery of the chip, or may be a rear copper layer of the chip that is formed during fabrication of a memory module, so that the chip has good selectivity. This may be specifically determined based on a specific product design and process condition. This is not limited in this embodiment of this application.

Certainly, the rear copper layer 23 is a structural layer that is selectively disposed. In other words, even if no rear copper layer is disposed on the rear side of the chip 2a, heat generated by the chip can still be quickly dissipated through the heat conduction portion. In comparison, for the chip 2a with the rear copper layer 23, the rear copper layer 23 can provide a good heat equalization capability, to further improve thermal conductivity on the rear side, and reduce operating temperature of the chip. For example, when the embedded substrate is used in a power module, power efficiency can be improved.

In a specific implementation, the heat conduction structures 8 arranged in the array may be in different structural forms. The following shows arrayed heat conduction structures in two structural forms from a perspective of a cutting position A-A in FIG. 4.

FIG. 5 is a layout diagram of arrayed heat-conduction blind vias. For example, in FIG. 5, in correspondence to the rear copper layer 23 of the chip, heat-conduction blind vias 8a are arranged in a form of an array with four rows and four columns. In another possible implementation solution, the heat-conduction blind vias 8a arranged in the array may be determined according to a requirement. For example, without constituting a limitation, the heat-conduction blind vias (Cu) may account for 10% within an area range on the rear side of the chip, and is not limited to the configuration form shown in FIG. 5.

FIG. 6 is a layout diagram of arrayed heat-conduction copper strips. For example, in FIG. 6, in correspondence to the rear copper layer 23 of the chip, heat-conduction copper strips 8b are arranged in a form of an array with five rows and one column. In another possible implementation solution, the heat-conduction copper strips 8b arranged in the array may alternatively be determined according to a requirement. For example, without constituting a limitation, the heat-conduction copper strips (Cu) may account for 30% within an area range on the rear side of the chip, and is not limited to the configuration form shown in FIG. 6.

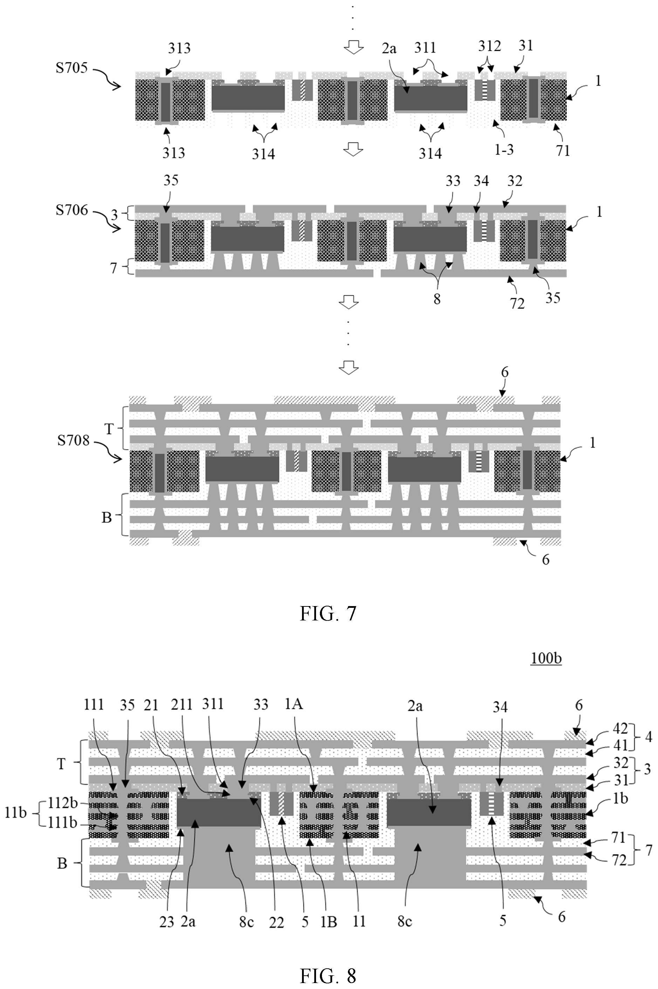

With reference to FIG. 7, the following briefly describes a fabrication process of the embedded substrate 100a described in FIG. 4.

Step S701: Prepare a core PCB.

Step S702: Prepare for embedding and mounting.

Step S703: Mount a chip and an electronic component, and perform press-fitting and filling.

Step S704: Press-fit a dielectric layer of a first front-side build-up layer.

For the foregoing step S701 to step S704, refer to the procedures of step S301 to step S304 shown in FIG. 3.

Step S705: Form a hole on a front side through an exposure and development process, and form a hole on a rear side.

Based on the exposure and development process, on the dielectric layer 31 of the first front-side build-up layer 3, a first hole 311 is formed in correspondence to a pad 22 of the chip 2a, a second hole 312 is formed in correspondence to a pin of the electronic component 5, and a third hole 313 is formed in correspondence to an interface pad 111 of a PTH through hole 11. In a specific implementation, after holes are formed, components are electrically connected to interfaces or pins and are exposed from corresponding holes, to construct corresponding conduction structures.

Based on a laser (laser)-based hole forming process, a fourth hole 314 is formed, in correspondence to an arrayed heat conduction structure, on an embedded filling material 1-3 layer on a rear side of the chip 2a, to construct a corresponding heat conduction structure 8. In a specific implementation, for a heat-conduction blind via or a heat-conduction copper strip, a fourth hole with a matching size and shape may be formed.

Step S706: Form conduction structures, heat conduction structures arranged in an array, surface copper of the first front-side build-up layer, and surface copper of a first rear-side build-up layer.

First, adhesive is removed. Then a seed layer may be first formed. In a specific implementation, the seed layer may be formed through a chemical copper plating or sputtering process. Then wall surfaces of the first hole 311, the second hole 312, and the third hole 313 are electroplated to form conductive blind vias, to form a first conduction structure 33, a second conduction structure 34, and a third conduction structure 35 respectively, and the fourth hole 314 is electroplated to form heat conduction structures 8 arranged in an array.

In addition, the front side and the rear side are electroplated to form surface copper, a surface copper layer on the front side is used to form a line layer 32 of the first front-side build-up layer, and a surface copper layer on the rear side is used to form a line layer 72 of the first rear-side build-up layer.

Step S707: Pattern the surface copper layer on the front side and the surface copper layer on the rear side. Refer to the procedure of step S307 shown in FIG. 3. Corresponding line layers are formed, to complete preparation of the first front-side build-up layer 3 and the first rear-side build-up layer 7.

Step S708: Form outer layers of a front-side build-up layer T and a rear-side build-up layer B, form an outer solder mask layer 6, and process a surface of outer-layer metal.

In a specific implementation, a quantity of outer build-up layers may be determined according to an overall product design requirement, and a corresponding fabrication procedure is formulated. This is not limited in this embodiment of this application.

In the embedded substrate architecture described in FIG. 4, the heat conduction structures arranged in the array serve as a heat conduction portion for reducing Z-direction thermal resistance. In another specific implementation, a heat conduction portion in a form of a copper block structure may be disposed on a rear side of a chip. FIG. 8 is a cross-sectional view of an architecture of still another embedded substrate according to an embodiment of this application. To clearly show a difference and a relationship between this implementation solution and the embodiment described in FIG. 4, components or structures with a same function are indicated by a same reference sign in the figures.

As shown in FIG. 8, a chip 2a and an electronic component 5 are embedded in a core PCB 1b of the embedded substrate 100b. A front side of the chip 2a faces a first surface 1A of the core PCB 1b, and a PI layer 21 on the front side of the chip 2a is aligned with the first surface 1A of the core PCB 1b. The first surface 1A of the core PCB 1b is covered with a front-side build-up layer T, and a second surface 1B of the core PCB 1b is covered with a rear-side build-up layer B.

Similarly, a dielectric layer 31 of a first front-side build-up layer 3 is made of an exposable and developable material, a dielectric layer 41 of a second front-side build-up layer 4 may be made of ABF, and dielectric layers of build-up layers of the rear-side build-up layer B may also be made of ABF.

A pad 22 of the chip 2a is connected to a line layer 32 of the front-side build-up layer T through a first conduction structure 33. On the dielectric layer 31 of the first front-side build-up layer 3, a hole for constructing the first conduction structure 33 is a first hole 311, and a second projection of the first hole 311 on the first surface 1A covers a first projection of a corresponding opening 211 of the PI layer 21 on the first surface 1A. In this way, the first conduction structure 33 can be constructed based on a size of the first hole 311 on the chip 2a side to a maximum extent, and the first conduction structure 33 with a large through-current cross section has high thermal conductivity. In addition, bonding stress between the line layer and the front side of the chip 2a can be reduced.

In comparison with the embedded substrate described in FIG. 4, a difference in this implementation solution lies in: A heat conduction portion on a rear side of the chip 2a is a heat-conduction copper block 8c, and a base of the core PCB 1b includes a plurality of line layers 11b, to achieve a large through-current capability and high thermal conductivity.

As shown in the figure, the rear side of the chip 2a abuts against the heat-conduction copper block 8c, an inner end side of the heat-conduction copper block 8c abuts against a rear copper layer 23 of the chip 2a, and an outer end side extends to a surface layer of the rear-side build-up layer B. In this way, heat generated by the chip is quickly dissipated through the heat-conduction copper block 8c.

In this implementation solution, a pin of the electronic component 5 embedded in the core PCB 1b may be connected to the line layer 32 of the front-side build-up layer T through a second conduction structure 34. For the plurality of line layers 11b disposed on the base of the core PCB 1b, for example, without constituting a limitation, the layers may be connected by filling a blind via 111b and an X-shaped hole 112b with copper. Based on a large through-current capability and high thermal conductivity, inter-layer wiring may be implemented in the base of the core PCB 1b according to a requirement, to make an architecture design more flexible.

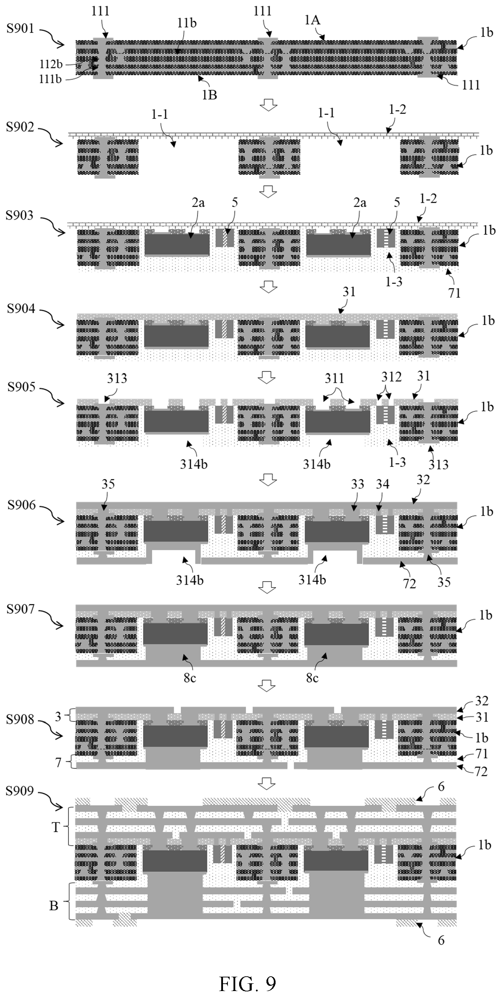

With reference to FIG. 9, the following briefly describes a fabrication process of the embedded substrate 100b described in FIG. 8.

Step S901: Prepare a core PCB 1b.

First, after an incoming material of an organic core PCB at a middle layer of a core PCB arrives, an X-shaped hole is processed at a position at which an X-shaped hole 112b is to be formed, hole filling and electroplating are performed to form surface copper, and then a surface of the middle layer is patterned. For example, film pressing, exposure, development, etching, and film stripping processes may be sequentially performed to obtained corresponding line layers. Then a build-up layer is press-fitted based on the middle layer of the core PCB, a blind via is processed at a position at which a blind via 111b is to be formed, hole filling and electroplating are performed to form surface copper, and then patterning is performed. Finally, after all build-up layers are completed, a surface copper layer is patterned to form an interface pad 111.

It should be noted that a base of an incoming material of each layer of the core PCB 1b may be made of an organic material, for example, but not limited to, an FR4, BT, or BT-like material. In addition, specific implementations of the foregoing procedures may be implemented by using the conventional technology. Details are not described herein again.

Step S902: Prepare for embedding and mounting.

An embedded slot 1-1 is provided on the core PCB 1b, and adhesive is removed. In a specific implementation, the slot may be provided through a UV laser, a CO2 laser, or another machining process. Then adhesive tape 1-2 is attached to a first surface 1A of the core PCB 1b.

Step S903: Mount a chip and an electronic component, and perform press-fitting and filling.

The chip 2a and the electronic component 5 are disposed in the embedded slot 1-1, with their front sides attached to the adhesive tape 1-2. Then a filling and press-fitting operation is performed. An embedded filling material 1-3 may be ABF. While filling gaps between components and between the components and the embedded slot, the embedded filling material 1-3 further forms a dielectric layer 71, bonded to a second surface 1B side of the core PCB 1b, of a first rear-side build-up layer 7.

Step S904: Press-fit a dielectric layer 31 of a first front-side build-up layer 3.

The adhesive tape 1-2 is removed, and the dielectric layer 31 made of an exposable and developable material is press-fitted on the core PCB 1b and is bonded to the front sides of the chip 2a and the electronic component 5.

Step S905: Form a hole on a front side through an exposure and development process.

Based on the exposure and development process, on the dielectric layer 31 of the first front-side build-up layer 3, a first hole 311 is formed in correspondence to a pad 22 of the chip 2a, a second hole 312 is formed in correspondence to a pin of the electronic component 5, and a third hole 313 is formed in correspondence to an interface pad 111 of a plurality of line layers 11b. In a specific implementation, after holes are formed, components are electrically connected to interfaces or pins and are exposed from corresponding holes, to construct corresponding conduction structures.

Based on a laser-based hole forming process, a fourth hole 314b is formed, in correspondence to a heat-conduction copper block 8c, on an embedded filling material 1-3 layer on a rear side of the chip 2a, to construct the corresponding heat-conduction copper block 8c.

Step S906: Form conduction structures, surface copper of the first front-side build-up layer, and surface copper of the first rear-side build-up layer.

First, adhesive is removed, and a seed layer may be formed. Then wall surfaces of the first hole 311, the second hole 312, and the third hole 313 are electroplated to form conductive blind vias, to form a first conduction structure 33, a second conduction structure 34, and a third conduction structure 35 respectively.

In addition, the front side and the rear side are electroplated to form surface copper, a surface copper layer on the front side is used to form a line layer 32 of the first front-side build-up layer, and a surface copper layer on the rear side is also electroplated to form a wall surface of the fourth hole 314b.

Step S907: Fill the fourth hole on the rear side through electroplating.

The heat-conduction copper block 8c is formed in the fourth hole 314b based on a process of filling a blind slot through electroplating.

Step S908: Pattern the surface copper layer on the front side and the surface copper layer on the rear side.

After surface processing, film pressing, exposure, development, etching, and film stripping processes may be sequentially performed to form corresponding line layers.

Step S909: Form outer build-up layers of a front-side build-up layer and a rear-side build-up layer, form an outer solder mask layer, and process a surface of outer-layer metal.

A quantity of outer build-up layers may be determined according to an overall product design requirement, and a corresponding fabrication procedure is formulated. This is not limited in this embodiment of this application.

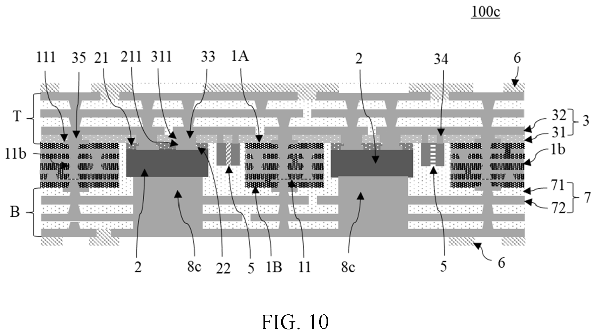

In the embedded substrate architectures described in FIG. 4 and FIG. 8, the heat conduction portion abuts against the rear copper layer of the chip. In another possible implementation solution, a heat conduction portion may directly abut against a rear side of a chip. FIG. 10 is a cross-sectional view of an architecture of still another embedded substrate according to an embodiment of this application. To clearly show a difference and a relationship between this implementation solution and the embodiment described in FIG. 8, components or structures with a same function are indicated by a same reference sign in the figures.

As shown in FIG. 10, a chip 2 and an electronic component 5 are embedded in a core PCB 1b of the embedded substrate 100c. In comparison with the embedded substrate described in FIG. 8, a difference in this implementation solution lies in: No rear copper layer is provided on a rear side of the chip 2, and a heat-conduction copper block 8c serving as a heat conduction portion abuts against a rear side of a base of the chip 2.

Other components and connection relationships of the embedded substrate 100c may be the same as those of the embedded substrate shown in FIG. 8. Details are not described herein again.

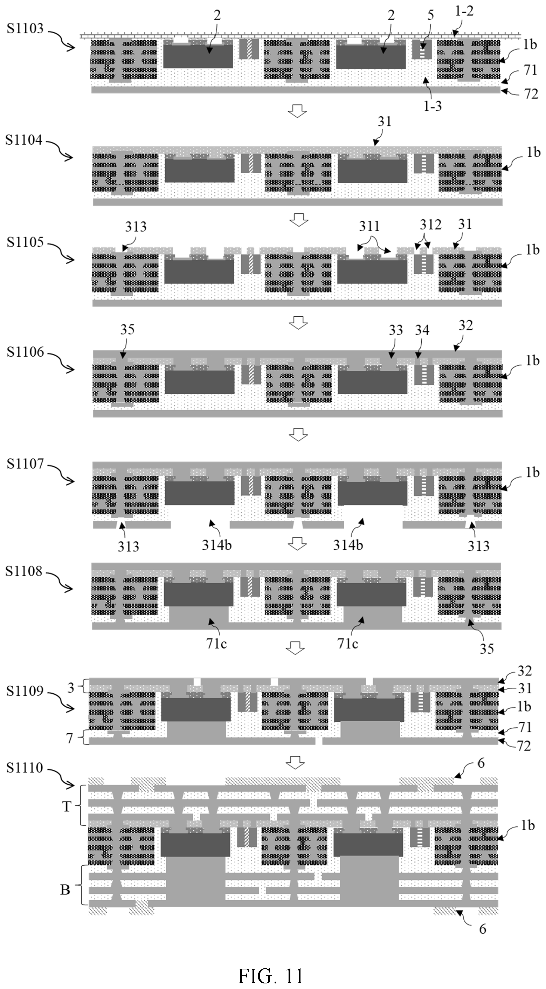

With reference to FIG. 11, the following briefly describes a fabrication process of the embedded substrate 100c described in FIG. 10.

Step S1101: Prepare a core PCB.

Step S1102: Prepare for embedding and mounting.

For the foregoing step S1101 and step S1102, refer to the procedures of step S901 and step S902 shown in FIG. 9.

Step S1103: Mount a chip and an electronic component, and perform press-fitting and filling.

Front sides of the chip 2 and the electronic component 5 are attached to adhesive tape 1-2, and then a filling and press-fitting operation is performed. An embedded filling material 1-3 may be ABF. While filling gaps between components and between the components and the embedded slot, the embedded filling material 1-3 further forms a dielectric layer 81, bonded to a second surface 1B side of the core PCB 1b, of a first rear-side build-up layer 7. Then the dielectric layer 81 is electroplated to form a surface copper layer, to form a line layer 82 of the first rear-side build-up layer 7.

Step S1104: Press-fit a dielectric layer 31 of a first front-side build-up layer 3.

The adhesive tape 1-2 is removed, and the dielectric layer 31 made of an exposable and developable material is press-fitted on the core PCB 1b and is bonded to the front sides of the chip 2 and the electronic component 5.

Step S1105: Form a hole on a front side through an exposure and development process.

Based on the exposure and development process, on the dielectric layer 31 of the first front-side build-up layer 3, a first hole 311 is formed in correspondence to a pad 22 of the chip 2, a second hole 312 is formed in correspondence to a pin of the electronic component 5, and a third hole 313 is formed in correspondence to an interface pad 111 of a PTH through hole 11. In a specific implementation, after holes are formed, components are electrically connected to interfaces or pins and are exposed from corresponding holes, to construct corresponding conduction structures.

Step S1106: Form conduction structures and surface copper of the first front-side build-up layer.

First, adhesive is removed, and a seed layer may be formed. Then wall surfaces of the first hole 311, the second hole 312, and the third hole 313 are electroplated to form conductive blind vias, to form a first conduction structure 33, a second conduction structure 34, and a third conduction structure 35 respectively. In addition, the front side is electroplated to form surface copper, and a surface copper layer on the front side is used to form a line layer 32 of the first front-side build-up layer.

Step S1107: Form a hole on a rear side.

A hole is formed based on a plasma (Plasma) process, and holes are provided on an embedded filling material 1-3 layer on the rear side and a surface copper layer on a rear side of the core PCB 1b. In another specific implementation, a laser-based hole forming process or a mechanical hole forming process may alternatively be used.

A fourth hole 314b is formed in correspondence to a heat-conduction copper block 8c, to construct the corresponding heat-conduction copper block 8c. A third hole 313 is formed in correspondence to an interface pad 111 of a plurality of line layers 11b, to construct a third conduction structure 35.

Step S1108: Electroplate the third hole and the fourth hole on the rear side.

Based on a process of filling a blind slot through electroplating, the third conduction structure 35 is formed in the third hole 313, and the heat-conduction copper block 8c is formed in the fourth hole 314b. The blind via is filled through electroplating, and the blind slot is filled through electroplating.

Step S1109: Pattern the surface copper layer on the front side and the surface copper layer on the rear side.

After surface processing, film pressing, exposure, development, etching, and film stripping processes may be sequentially performed to form corresponding line layers.

Step S1110: Form outer build-up layers of a front-side build-up layer and a rear-side build-up layer, form an outer solder mask layer, and process a surface of outer-layer metal.

A quantity of outer build-up layers may be determined according to an overall product design requirement, and a corresponding fabrication procedure is formulated. This is not limited in this embodiment of this application.

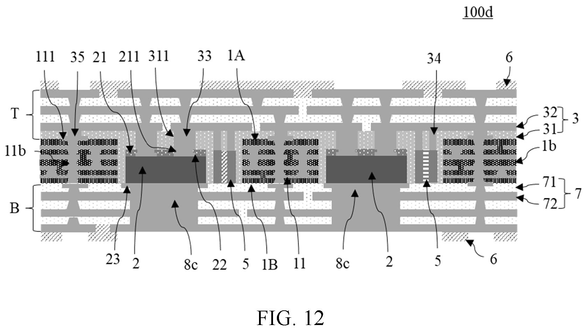

In the embedded substrate architectures described in FIG. 1, FIG. 4, FIG. 8, and FIG. 10, both the PI layer 21 on the front side of the chip and the pin side of the electronic component 5 are aligned with the first surface of the core PCB. In another specific implementation, a chip and an electronic component that are embedded in a core PCB may alternatively be arranged with their rear sides aligned with a second surface of the core PCB. FIG. 12 is a cross-sectional view of an architecture of still another embedded substrate according to an embodiment of this application. To clearly show a difference and a relationship between this implementation solution and the embodiment described in FIG. 8, components or structures with a same function are indicated by a same reference sign in the figures.

As shown in FIG. 12, a chip 2 and an electronic component 5 are embedded in a core PCB 1b of the embedded substrate 100d. In comparison with the embedded substrate described in FIG. 8, a difference in this implementation solution lies in: Rear sides of the chip 2 and the electronic component 5 are aligned with a second surface 1B of the core PCB 1b.

In correspondence to a heat-conduction copper block 8c that serves as a heat conduction portion, the chip 2 is disposed downward, and a rear copper layer 23 on a rear side of the chip 2 serves as a direct carrying layer for forming a blind via. In a specific implementation, gaps between components (the chip 2 and the electronic component 5) and between the components and an embedded slot of the core PCB 1b may be filled with an exposable and developable material or an ABF material.

Other components and connection relationships of the embedded substrate 100d may be the same as those of the embedded substrate shown in FIG. 8. Details are not described herein again.

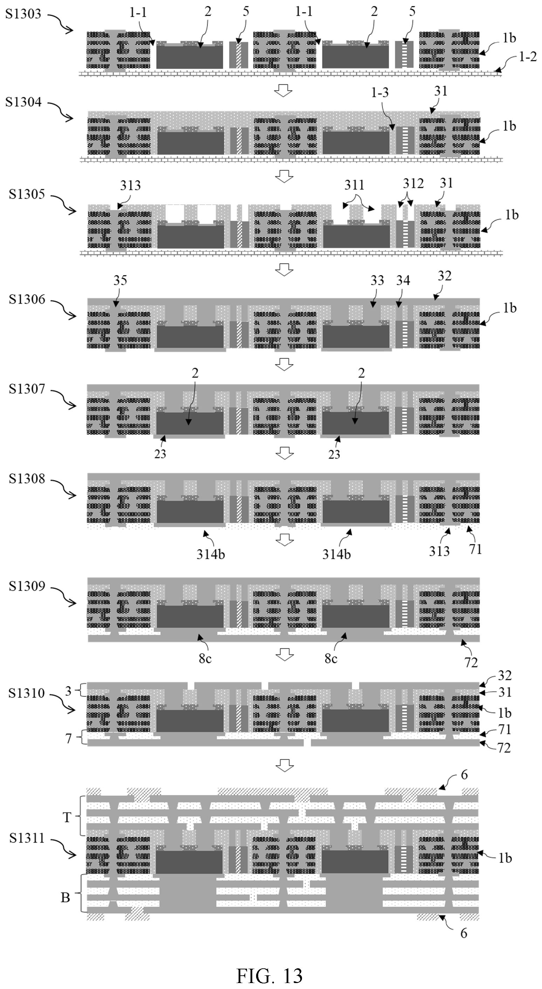

With reference to FIG. 13, the following briefly describes a fabrication process of the embedded substrate 100d described in FIG. 12 by using an example in which an exposable and developable material serves as an embedded filling material 1-3.

Step S1301: Prepare a core PCB.

Step S1302: Prepare for embedding and mounting, and attach adhesive tape to a second surface of the core PCB.

For the foregoing step S1301 and step S1302, refer to the procedures of step S901 and step S902 shown in FIG. 9.

Step S1303: Mount a chip and an electronic component.

The chip 2 and the electronic component 5 are disposed in an embedded slot 1-1 of the core PCB 1b, with their rear sides attached to adhesive tape 1-2.

Step S1304: Perform press-fitting and filling.

An exposable and developable material is used as an embedded filling material 1-3 that forms a dielectric layer 31 of a first front-side build-up layer 3 while filling gaps between components and between the components and the embedded slot.

Step S1305: Form a hole on a front side through an exposure and development process.

Based on the exposure and development process, on the dielectric layer 31 of the first front-side build-up layer 3, a first hole 311 is formed in correspondence to a pad 22 of the chip 2, a second hole 312 is formed in correspondence to a pin of the electronic component 5, and a third hole 313 is formed in correspondence to an interface pad 111 of a PTH through hole 11. In a specific implementation, after holes are formed, components are electrically connected to interfaces or pins and are exposed from corresponding holes, to construct corresponding conduction structures.

Step S1306: Form conduction structures and surface copper of the first front-side build-up layer.

After the adhesive tape 1-2 is removed, a seed layer is first formed. Then wall surfaces of the first hole 311, the second hole 312, and the third hole 313 are electroplated to form conductive blind vias, to form a first conduction structure 33, a second conduction structure 34, and a third conduction structure 35 respectively. In addition, the front side is electroplated to form surface copper, and a surface copper layer on the front side is used to form a line layer 32 of the first front-side build-up layer.

Step S1307: Prepare a rear copper layer on a rear side of the chip.

A copper layer is formed on the chip 2 through a sputtering process or an electroplating process on the rear side, and is patterned to form the rear copper layer 23.

Step S1308: Form a hole on the rear side.

A hole is formed based on a laser process, and holes are provided on an embedded filling material 1-3 layer on the rear side and a surface copper layer on a rear side of the core PCB 1b. In another specific implementation, a plasma hole forming process or a mechanical hole forming process may alternatively be used.

A fourth hole 314b is formed in correspondence to a heat-conduction copper block 8c, to construct the corresponding heat-conduction copper block 8c. A third hole 313 is formed in correspondence to an interface pad 111 of a plurality of line layers 11b, to construct a third conduction structure 35.

Step S1309: Form the third conduction structure and the heat-conduction copper block on the rear side, and surface copper of a first rear-side build-up layer.

Specifically, a seed layer may be first formed. In a specific implementation, the seed layer may be formed through a chemical copper plating or sputtering process. Then wall surfaces of the third hole 313 and the fourth hole 314b are electroplated to form the third conduction structure 35 and a structure of the heat-conduction copper block 314c.

In addition, the rear side is electroplated to form surface copper, and a surface copper layer on the rear side is used to form a line layer 72 of the first rear-side build-up layer.

Step S1310: Pattern the surface copper layer on the front side and the surface copper layer on the rear side.

After surface processing, film pressing, exposure, development, etching, and film stripping processes may be performed to form corresponding line layers, to complete preparation of the first front-side build-up layer 3 and the first rear-side build-up layer 7.

Step S1311: Form outer build-up layers of a front-side build-up layer and a rear-side build-up layer, form an outer solder mask layer, and process a surface of outer-layer metal.

A quantity of outer build-up layers may be determined according to an overall product design requirement, and a corresponding fabrication procedure is formulated. This is not limited in this embodiment of this application.

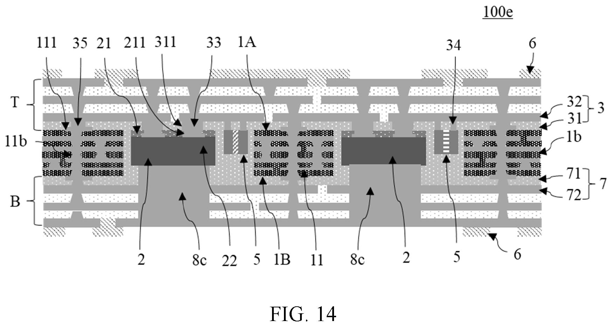

In the embedded substrate architecture described in FIG. 12, the exposable and developable material may be used as an embedded material for the gaps between the components and between the components and the embedded slot of the core PCB. In another possible implementation, a dielectric layer of a first rear-side build-up layer on a rear side of a core PCB may alternatively be made of an exposable and developable material. FIG. 14 is a cross-sectional view of an architecture of another embedded substrate according to an embodiment of this application. To clearly show a difference and a relationship between this implementation solution and the embodiment described in FIG. 12, components or structures with a same function are indicated by a same reference sign in the figures.

As shown in FIG. 14, a chip 2 and an electronic component 5 are embedded in a core PCB 1b of the embedded substrate 100e. Both sides of the core PCB 1b each include three build-up layers. A front-side build-up layer T includes three sequentially stacked layers: one first front-side build-up layer 3 and two second front-side build-up layers 4. A rear-side build-up layer B includes three sequentially stacked layers: one first rear-side build-up layer 7 and two second rear-side build-up layers 9. Compared with the first rear-side build-up layer 7, the second rear-side build-up layer 9 is located at an outer layer of the rear-side build-up layer B. In a specific implementation, a quantity second rear-side build-up layers 9 may be set according to a requirement, and is not limited to the two layers shown in the figure.

In comparison with the embedded substrate described in FIG. 12, a difference in this implementation solution lies in: Front sides of the chip 2 and the electronic component 5 are aligned with a first surface 1A of the core PCB 1b, and a dielectric layer 71 of the first rear-side build-up layer 7 is made of an exposable and developable material.

The chip 2 has no rear copper layer, and both a heat-conduction copper block 8c serving as a heat conduction portion and a third hole 312 on a rear side of the core PCB 1b are formed through an exposure and development process, to achieve higher processability. In a specific implementation, dielectric layers of other layers (the second front-side build-up layer 4 and the second rear-side build-up layer 9) of the front-side build-up layer T and the rear-side build-up layer B may be made of an ABF material.

Other components and connection relationships of the embedded substrate 100e may be the same as those of the embedded substrate shown in FIG. 12. Details are not described herein again.

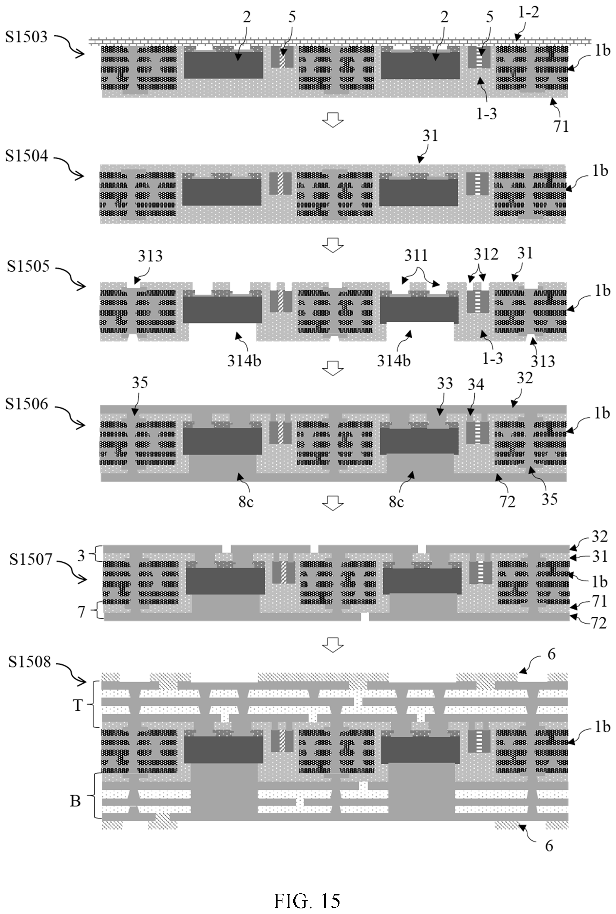

With reference to FIG. 15, the following briefly describes a fabrication process of the embedded substrate 100e described in FIG. 14.

Step S1501: Prepare a core PCB.

Step S1502: Prepare for embedding and mounting.

For the foregoing step S1501 and step S1502, refer to the procedures of step S901 and step S902 shown in FIG. 9.

Step S1503: Mount a chip and an electronic component, and perform press-fitting and filling.

The chip 2 and the electronic component 5 are disposed in an embedded slot 1-1 of the core PCB 1b, with their front sides attached to adhesive tape 1-2. An exposable and developable material is used as an embedded filling material 1-3 that forms a dielectric layer 71 of a first rear-side build-up layer 7 while filling gaps between components and between the components and the embedded slot.

Step S1504: Press-fit a dielectric layer 31 of a first front-side build-up layer 3.

The adhesive tape 1-2 is removed, an exposable and developable material is press-fitted on the core PCB 1b to form the dielectric layer 31, and the dielectric layer 31 is bonded to the front sides of the chip 2 and the electronic component 5.

Step S1505: Form a hole through an exposure and development process.

Based on the exposure and development process, on the dielectric layer 31 of the first front-side build-up layer 3, a first hole 311 is formed in correspondence to a pad 22 of the chip 2, a second hole 312 is formed in correspondence to a pin of the electronic component 5, and a third hole 313 is formed in correspondence to an interface pad 111 of a plurality of line layers 11b. On an embedded filling material 1-3 layer on a rear side of the chip 2, a fourth hole 314b is formed in correspondence to a heat-conduction copper block, and the rear side of the chip 2 is exposed from the fourth hole 314b.

Step S1506: Form conduction structures, surface copper of the first front-side build-up layer, and surface copper of the first rear-side build-up layer.

First, a seed layer is formed. Then wall surfaces of the first hole 311, the second hole 312, and the third hole 313 are electroplated to form conductive blind vias, to form a first conduction structure 33, a second conduction structure 34, and a third conduction structure 35 respectively, and the fourth hole 314 is electroplated to form a heat-conduction copper block 8c. In addition, a front side and the rear side are electroplated to form surface copper, a surface copper layer on the front side is used to form a line layer 32 of the first front-side build-up layer, and a surface copper layer on the rear side is used to form a line layer 72 of the first rear-side build-up layer.

Step S1507: Pattern the surface copper layer on the front side and the surface copper layer on the rear side.

After surface processing, film pressing, exposure, development, etching, and film stripping processes may be performed to form corresponding line layers, to complete preparation of the first front-side build-up layer 3 and the first rear-side build-up layer 7.

Step S1508: Form outer build-up layers of a front-side build-up layer and a rear-side build-up layer, form an outer solder mask layer, and process a surface of outer-layer metal.

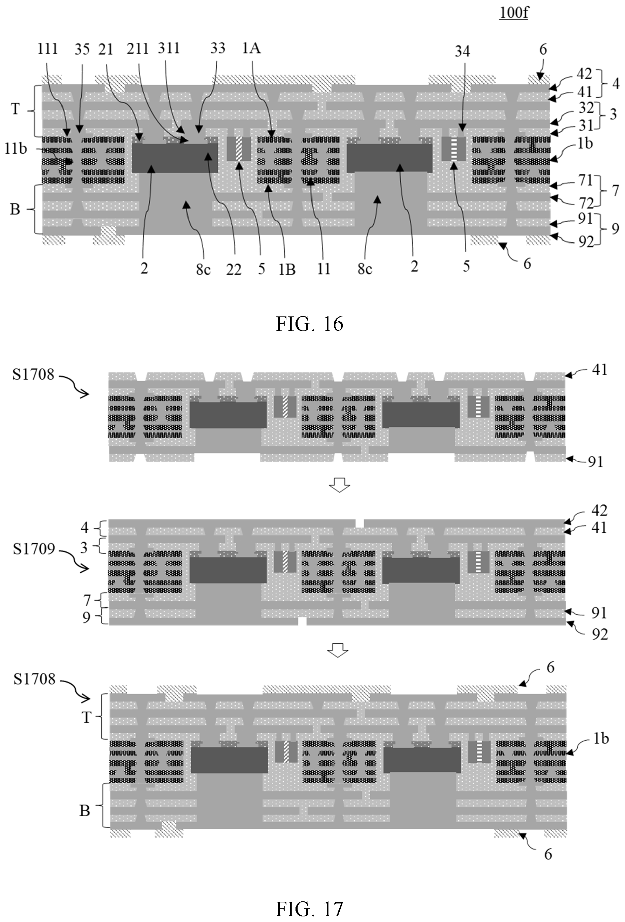

In the embedded substrate architecture described in FIG. 14, all build-up layers of the front-side build-up layer T and the rear-side build-up layer B other than the first front-side build-up layer 3 and the first rear-side build-up layer 7 are made of an ABF material. In another possible implementation, dielectric layers of other build-up layers of the front-side build-up layer T and the rear-side build-up layer B may alternatively be made of an exposable and developable material. FIG. 16 is a cross-sectional view of an architecture of another embedded substrate according to an embodiment of this application. To clearly show a difference and a relationship between this implementation solution and the embodiment described in FIG. 14, components or structures with a same function are indicated by a same reference sign in the figures.

As shown in FIG. 16, a chip 2 and an electronic component 5 are embedded in a core PCB 1b of the embedded substrate 100f. Both sides of the core PCB 1b each include three build-up layers. Dielectric layers of all build-up layers of a front-side build-up layer T and a rear-side build-up layer B may be made of an exposable and developable material. In this arrangement, all outer-layer blind vias and blind slots are formed through an exposure and development process, to achieve higher efficiency.

Other components and connection relationships of the embedded substrate 100f may be the same as those of the embedded substrate shown in FIG. 14. Details are not described herein again.

With reference to FIG. 17, the following briefly describes a fabrication process of the embedded substrate 100f described in FIG. 16.

Step S1701: Prepare a core PCB.

Step S1702: Prepare for embedding and mounting.

Step S1703: Mount a chip and an electronic component, and perform press-fitting and filling.

Step S1704: Press-fit a dielectric layer of a first front-side build-up layer.

Step S1705: Form a hole through an exposure and development process.

Step S1706: Form conduction structures, surface copper of the first front-side build-up layer, and surface copper of a first rear-side build-up layer.

Step S1707: Pattern a surface copper layer on a front side and a surface copper layer on a rear side.

For the foregoing step S1701 to step S1707, refer to the procedures of step S1501 to step S1507 shown in FIG. 9.

Step S1708: Form dielectric layers of a second front-side build-up layer and a second rear-side build-up layer through press-fitting, and form a hole through an exposure and development process.

Based on the exposure and development process, corresponding holes are respectively formed on a dielectric layer 41 of the second front-side build-up layer and a dielectric layer 91 of the second rear-side build-up layer, to construct line layers and heat-conduction copper block 8c structures of corresponding build-up layers.

Step S1709: Form line layers of the second front-side build-up layer and the second rear-side build-up layer.

In a specific implementation, a surface copper layer may be formed on each of the front side and the rear side through an electroplating process. After surface processing, film pressing, exposure, development, etching, and film stripping processes may be performed to form corresponding line layers, to complete preparation of the second front-side build-up layer 4 and the second rear-side build-up layer 9.

Step S1710: Form other outer build-up layers of a front-side build-up layer and a rear-side build-up layer, form an outer solder mask layer, and process a surface of outer-layer metal.

For formation of the other outer build-up layers of the front-side build-up layer and the rear-side build-up layer, refer to the procedures of step S1708 and step S1709 shown in the figure. Details are not described herein again.

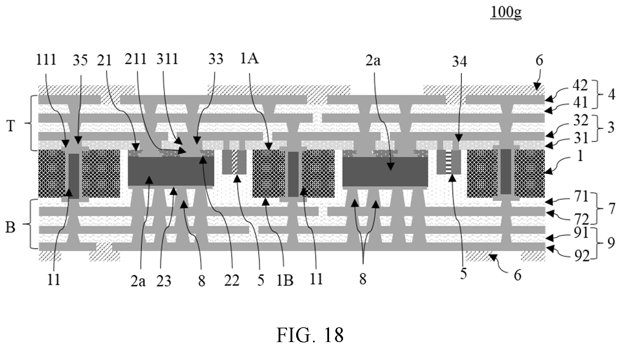

In the embedded substrate architecture described in FIG. 4, all build-up layers of the front-side build-up layer T other than the first front-side build-up layer 3, and all build-up layers of the rear-side build-up layer B are made of an ABF material. In another possible implementation, dielectric layers of other build-up layers of the front-side build-up layer T and all build-up layers of the rear-side build-up layer B may alternatively be made of a PP material. FIG. 18 is a cross-sectional view of an architecture of another embedded substrate according to an embodiment of this application. To clearly show a difference and a relationship between this implementation solution and the embodiment described in FIG. 4, components or structures with a same function are indicated by a same reference sign in the figures.

As shown in FIG. 18, a chip 2 and an electronic component 5 are embedded in a core PCB 1b of the embedded substrate 100g, and an embedded material between components and between the components and an embedded slot of the core PCB may be ABF. Both sides of the core PCB 1b each include three build-up layers. An outer layer (a second front-side build-up layer 4) of a front-side build-up layer T and dielectric layers of build-up layers (a first rear-side build-up layer 7 and a second rear-side build-up layer 9) of a rear-side build-up layer B are made of a PP material. In this arrangement, compared with the ABF material, the PP material has good strength and high temperature resistance performance, so that overall strength of the substrate is enhanced.

In this implementation solution, a rear side of the chip 2a abuts against heat conduction structures 8 arranged in an array, and a heat conduction portion formed by the arrayed heat conduction structures 8 can effectively reduce Z-direction thermal resistance on the rear side of the chip 2a, to quickly dissipate heat generated by the chip, and achieve high thermal conductivity. In addition, an inner end side of each heat conduction structure 8 abuts against a rear copper layer 23 of the chip 2a, and an outer end side of each heat conduction structure 8 extends to a surface layer of the rear-side build-up layer B. The heat conduction structures 8 arranged in the array sequentially pass through the ABF embedded material and the PP build-up layer material, to achieve pinning effect at a joint interface between the ABF embedded material and the PP build-up layer material, to reduce a risk of delamination between the ABF embedded material and the PP build-up layer material. Costs of PP are lower.

Other components and connection relationships of the embedded substrate 100g may be the same as those of the embedded substrate shown in FIG. 14. Details are not described herein again.

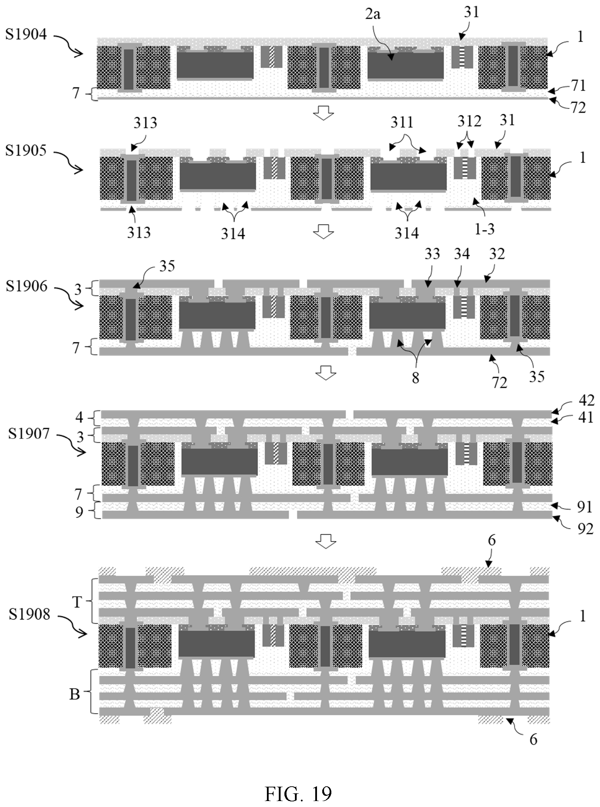

With reference to FIG. 19, the following briefly describes a fabrication process of the embedded substrate 100g described in FIG. 18.

Step S1901: Prepare a core PCB.

Step S1902: Prepare for embedding and mounting.

Step S1903: Mount a chip and an electronic component, and perform press-fitting and filling.

ABF is used as an embedded filling material 1-3 to fill gaps between components and between the components and an embedded slot of the core PCB.

For the foregoing step S1901 to step S1903, refer to the procedures of step S301 to step S303 shown in FIG. 3.

Step S1904: Press-fit a dielectric layer of a first front-side build-up layer, and press-fit a first rear-side build-up layer.

Adhesive tape 1-2 is removed, an exposable and developable material is press-fitted on the core PCB 1 to form the dielectric layer 31 of the first front-side build-up layer, and the dielectric layer 31 is bonded to front sides of the chip 2 and the electronic component 5. In addition, a PP material and a copper foil are press-fitted on the core PCB 1 to form the first rear-side build-up layer 7.

Step S1905: Form a hole on a front side through an exposure and development process, and form a hole on a rear side.

Based on the exposure and development process, on the dielectric layer 31 of the first front-side build-up layer 3, a first hole 311 is formed in correspondence to a pad 22 of the chip 2a, a second hole 312 is formed in correspondence to a pin of the electronic component 5, and a third hole 313 is formed in correspondence to an interface pad 111 of a PTH through hole 11. In a specific implementation, after holes are formed, components are electrically connected to interfaces or pins and are exposed from corresponding holes, to construct corresponding conduction structures.

Based on a laser-based hole forming process, a third hole 313 is formed, in correspondence to the interface pad 111 of the PTH through hole 11, on the first rear-side build-up layer 7; and a fourth hole 314 is formed, in correspondence to an arrayed heat conduction structure, on an embedded filling material 1-3 layer on a rear side of the chip 2a, to construct a corresponding heat conduction structure 8.

Step S1906: Form conduction structures, heat conduction structures arranged in an array, surface copper of the first front-side build-up layer, and surface copper of a first rear-side build-up layer, and perform patterning.

First, adhesive is removed. Then a seed layer may be first formed. Then wall surfaces of the first hole 311, the second hole 312, and the third hole 313 are electroplated to form conductive blind vias, to form a first conduction structure 33, a second conduction structure 34, and a third conduction structure 35 respectively, and the fourth hole 314 is electroplated to form heat conduction structures 8 arranged in an array.

In addition, the front side and the rear side are electroplated to form surface copper, and the surface copper is patterned. A surface copper layer on the front side is used to form a line layer 32 of the first front-side build-up layer, and a surface copper layer on the rear side is used to form a line layer 72 of the first rear-side build-up layer, to complete preparation of the first front-side build-up layer 3 and the first rear-side build-up layer 7.

Step S1907: Form a second front-side build-up layer and a second rear-side build-up layer.

In a specific implementation, a PP material and a copper foil are respectively press-fitted on the first front-side build-up layer and the first rear-side build-up layer. Then holes are formed through laser, corresponding surface copper layers are respectively formed on the front side and the rear side through an electroplating process, and surfaces are patterned to form corresponding line layers, to complete preparation of the second front-side build-up layer 4 and the second rear-side build-up layer 9.

Step S1908: Form other outer build-up layers of a front-side build-up layer and a rear-side build-up layer, form an outer solder mask layer, and process a surface of outer-layer metal.

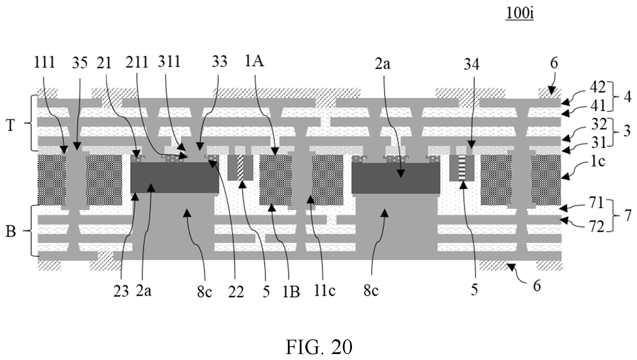

In the foregoing implementation solutions, the base of the core PCB is made of an organic material. In another specific implementation, a base of a core PCB may alternatively be made of a glass material. FIG. 20 is a cross-sectional view of an architecture of another embedded substrate according to an embodiment of this application. To clearly show a difference and a relationship between this implementation solution and the embodiment described in FIG. 8, components or structures with a same function are indicated by a same reference sign in the figures.

As shown in FIG. 20, a chip 2a and an electronic component 5 are embedded in a core PCB 1c of the embedded substrate 100i, and front sides of the chip 2a and the electronic component 5 are aligned with a first surface 1A of the core PCB 1c. Both sides of the core PCB 1c each include three build-up layers: a front-side build-up layer T and a rear-side build-up layer B.

In comparison with the embedded substrate described in FIG. 8, a difference in this implementation solution lies in: The core PCB 1c is a glass core PCB, and a TGV through hole 11c formed through a TGV process is provided on a base of the core PCB 1c, to implement conduction between the first surface 1A and a second surface 1B of the core PCB 1c, and provide functions of power supply, signal transmission, and heat conduction. In this way, the glass substrate framework has a high modulus, so that overall strength of the substrate is improved. In addition, based on adjustability of a CTE of the glass material, in a specific implementation, glass whose CTE is close to a CTE of a base material of the chip may be selected, to effectively reduce structural stress. In addition, thermal conductivity and a through-current capability in a Z direction can be further improved based on high hole density and a good hole filling capability of the TGV.

The chip 2a has a rear copper layer 23, and a heat-conduction copper block 8c that abuts against the rear copper layer 23 can effectively reduce Z-direction thermal resistance on a rear side of the chip 2a. Similarly, the heat-conduction copper block 8c sequentially passes through an ABF embedded material and a PP build-up layer material, to achieve pinning effect at a joint interface between the ABF embedded material and the PP build-up layer material, to reduce a risk of delamination between the ABF embedded material and the PP build-up layer material.

In this implementation solution, ABF is used as an embedded material to fill gaps between components and between the components and an embedded slot of the core PCB. A dielectric layer 31 of a first front-side build-up layer 3 is formed through an exposure and development process, and dielectric layers of a second front-side build-up layer 4 and all build-up layers of a rear-side build-up layer B are made of PP.

Other components and connection relationships of the embedded substrate 100i may be the same as those of the embedded substrate shown in FIG. 8. Details are not described herein again.

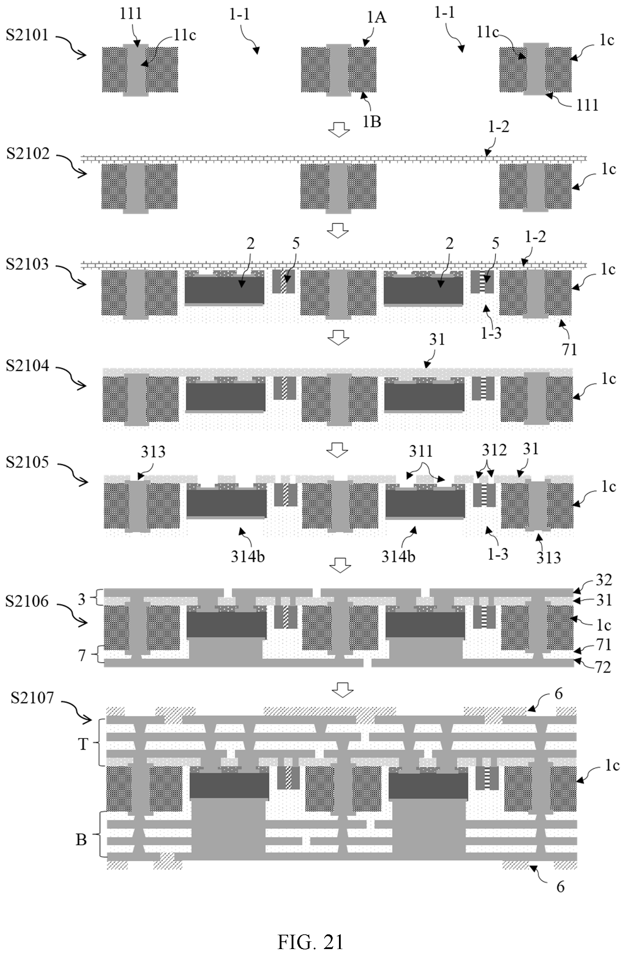

With reference to FIG. 21, the following briefly describes a fabrication process of the embedded substrate 100i described in FIG. 20.

Step S2101: Prepare a core PCB 1c.

First, after an incoming material of a glass core PCB arrives, through a laser processing technology, a hole is formed at a position of a TGV through hole 11c, and a slot is formed at a position of an embedded component. Then the hole is filled through electroplating based on a TGV process, to form an interface pad 111.

Step S2102: Prepare for embedding and mounting, and attach adhesive tape 1-2 to a first surface 1A of the core PCB 1c.

Step S2103: Mount a chip and an electronic component, and perform press-fitting and filling.

Specifically, the chip 2a and the electronic component 5 are disposed in an embedded slot 1-1, with their front sides attached to the adhesive tape 1-2. Then a filling and press-fitting operation is performed. An embedded filling material 1-3 may be ABF, or may be selected based on an actual process condition.

Herein, while press-fitting and filling gaps between components and between the components and the embedded slot, the embedded filling material 1-3 further forms a dielectric layer 71, bonded to a second surface 1B side of the core PCB 1c, of a first rear-side build-up layer 7.

Step S2104: Press-fit a dielectric layer 31 of a first front-side build-up layer 3.

The adhesive tape 1-2 is removed, an exposable and developable material is press-fitted on the core PCB 1c to form the dielectric layer 31, and the dielectric layer 31 is bonded to the front sides of the chip 2a and the electronic component 5.

Step S2105: Form a hole on a front side through an exposure and development process, and form a hole on a rear side.

Specifically, on the dielectric layer 31 of the first front-side build-up layer 3, a first hole 311 is formed in correspondence to a pad 22 of the chip 2a, a second hole 312 is formed in correspondence to a pin of the electronic component 5, and a third hole 313 is formed in correspondence to the interface pad 111 of the TGV through hole 11c. In a specific implementation, after holes are formed, components are electrically connected to interfaces or pins and are exposed from corresponding holes, to construct conduction structures.

Based on a laser-based hole forming process, on an embedded filling material 1-3 layer on a rear side of the chip 2a, a third hole 313 is formed in correspondence to the interface pad 111 of the TGV through hole 11c, and a fourth hole 314b is formed in correspondence to a heat-conduction copper block 8c, to construct the corresponding heat-conduction copper block 8c.

Step S2106: Form conduction structures, surface copper of the first front-side build-up layer, and surface copper of the first rear-side build-up layer, and pattern surfaces.

First, adhesive is removed. Then a seed layer may be first formed. Then wall surfaces of the first hole 311, the second hole 312, and the third hole 313 are electroplated to form conductive blind vias, to form a first conduction structure 33, a second conduction structure 34, and a third conduction structure 35 respectively, and the fourth hole 314b is electroplated to form the heat-conduction copper block 8c.

In addition, the front side and the rear side are electroplated to form surface copper, a surface copper layer on the front side is patterned to form a line layer 32 of the first front-side build-up layer, and a surface copper layer on the rear side is patterned to form a line layer 72 of the first rear-side build-up layer.

Step S2107: Form outer layers of a front-side build-up layer T and a rear-side build-up layer B, form an outer solder mask layer 6, and process a surface of outer-layer metal.

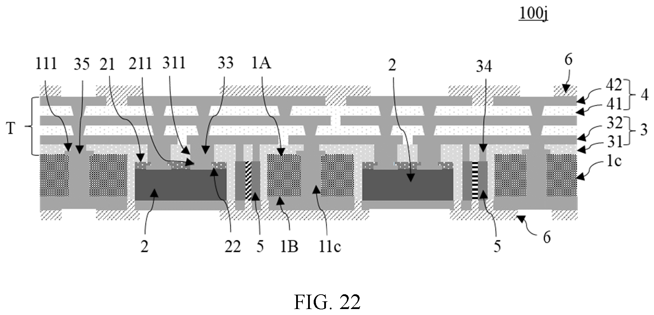

In the foregoing implementation solution, build-up layers are disposed on both sides of the core PCB: the front-side build-up layer T and the rear-side build-up layer B. In a specific implementation, alternatively, only the front-side build-up layer T may be disposed. FIG. 22 is a cross-sectional view of an architecture of another embedded substrate according to an embodiment of this application. To clearly show a difference and a relationship between this implementation solution and the embodiment described in FIG. 20, components or structures with a same function are indicated by a same reference sign in the figures.

As shown in FIG. 22, a chip 2 and an electronic component 5 are embedded in a core PCB 1c of the embedded substrate 100j. In comparison with the embedded substrate described in FIG. 20, a difference in this implementation solution lies in: Rear sides of the chip 2 and the electronic component 5 are aligned with a second surface 1B of the glass core PCB 1c, a front-side build-up layer T is disposed on a first surface A side of the core PCB 1c, and no rear-side build-up layer B is disposed. In other words, build-up layers of the embedded substrate are asymmetrically arranged. In this way, a heat conduction path on a rear side of the chip is short, and thermal conductivity can be maximized. This conforms to a product evolution trend of an ultrathin embedded architecture.

The core PCB 1c is a glass core PCB, and a TGV through hole 11c is provided on a base of the core PCB 1c, to implement conduction between the first surface 1A and the second surface 1B of the core PCB 1c. In this way, the glass substrate framework has a high modulus, so that overall strength of the substrate is improved. In a specific implementation, glass whose CTE is close to a CTE of a base material of the chip may be selected, to effectively reduce structural stress. In addition, thermal conductivity and a through-current capability in a Z direction can be improved based on high hole density and a good hole filling capability of the TGV.

In this implementation solution, both a dielectric layer 31 of a first front-side build-up layer 3 and an embedded material for filling gaps between components and between the components and an embedded slot of the core PCB are exposable and developable materials.

Other components and connection relationships of the embedded substrate 100j may be the same as those of the embedded substrate shown in FIG. 20. Details are not described herein again.

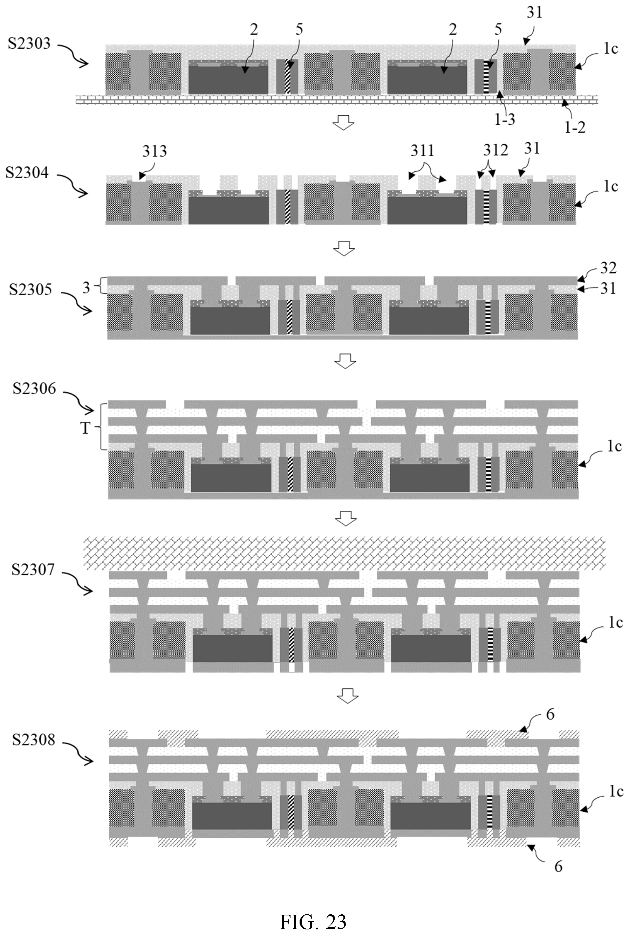

With reference to FIG. 23, the following briefly describes a fabrication process of the embedded substrate 100j described in FIG. 22.

Step S2301: Prepare a core PCB 1c.

Step S2302: Prepare for embedding and mounting, and attach adhesive tape 1-2 to a second surface 1B of the core PCB 1c.

For the foregoing step S2301 and step S2302, refer to the procedures of step S2101 and step S2102 shown in FIG. 21.

Step S2303: Mount a chip and an electronic component, and perform press-fitting and filling.

Specifically, the chip 2a and the electronic component 5 are disposed in an embedded slot 1-1, with their rear sides attached to the adhesive tape 1-2. Then a filling and press-fitting operation is performed. An embedded filling material 1-3 may be an exposable and developable material. While press-fitting and filling gaps between components and between the components and the embedded slot, the embedded filling material 1-3 further forms a dielectric layer 31, bonded to a first surface 1A side of the core PCB 1c, of a first front-side build-up layer 3.

Step S2304: Form a hole on a front side through an exposure and development process.

The adhesive tape 1-2 is removed. On the dielectric layer 31 of the first front-side build-up layer 3, a first hole 311 is formed in correspondence to a pad 22 of the chip 2a, a second hole 312 is formed in correspondence to a pin of the electronic component 5, and a third hole 313 is formed in correspondence to an interface pad 111 of a TGV through hole 11c. In a specific implementation, after holes are formed, components are electrically connected to interfaces or pins and are exposed from corresponding holes, to construct conduction structures.

Step S2305: Form conduction structures and surface copper of the first front-side build-up layer, and pattern a surface.

First, adhesive is removed. Then a seed layer may be first formed. Then wall surfaces of the first hole 311, the second hole 312, and the third hole 313 are electroplated to form conductive blind vias, to form a first conduction structure 33, a second conduction structure 34, and a third conduction structure 35 respectively.

In addition, the front side and a rear side are electroplated to form surface copper, a surface copper layer on the front side is patterned to form a line layer 32 of the first front-side build-up layer, and a surface copper layer on the rear side is used to form a rear-side interface of the substrate.

Step S2306: Form an outer layer of a front-side build-up layer T.

Step S2307: Pattern the rear-side copper layer.

In a specific implementation, a thickness of the rear-side copper layer may be increased, to form the rear-side interface of the substrate through patterning.

Step S2308: Form an outer solder mask layer 6, and process a surface of outer-layer metal.

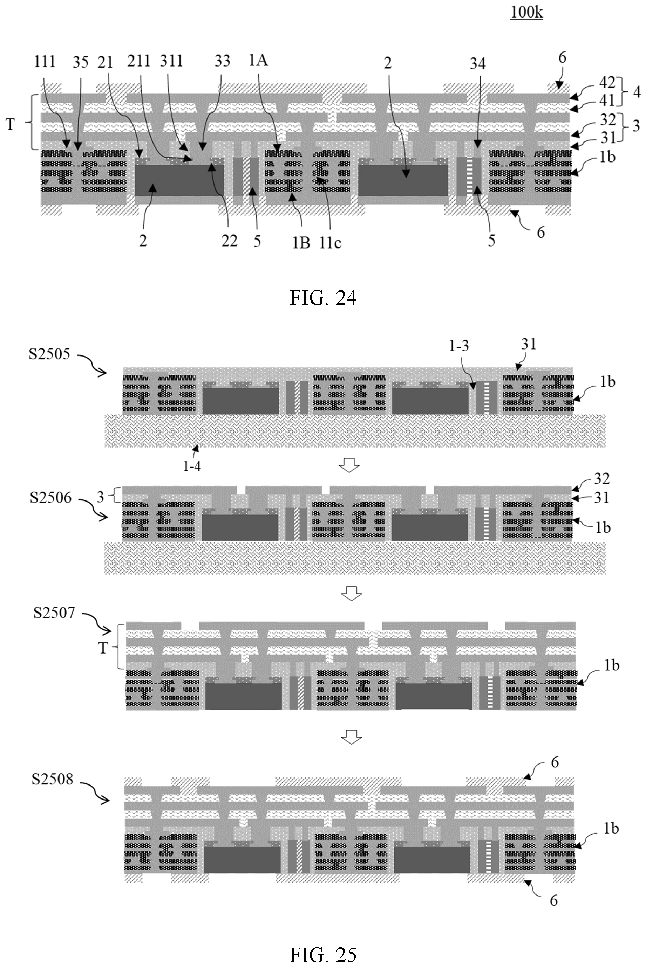

In the foregoing implementation solution in which the build-up layers are asymmetrically arranged, the base core PCB is a glass core PCB. In a specific implementation, a core PCB made of an organic material may alternatively be used for an embedded substrate in which build-up layers are asymmetrically arranged. FIG. 24 is a cross-sectional view of an architecture of another embedded substrate according to an embodiment of this application. To clearly show a difference and a relationship between this implementation solution and the embodiment described in FIG. 22, components or structures with a same function are indicated by a same reference sign in the figures.

As shown in FIG. 24, a chip 2 and an electronic component 5 are embedded in a core PCB 1b of the embedded substrate 100k. In comparison with the embedded substrate described in FIG. 22, a difference in this implementation solution lies in: The core PCB 1b is a core PCB made of an organic material. For example, without constituting a limitation, a base of the core PCB 1b includes a plurality of line layers 11b, to achieve a large through-current capability and high thermal conductivity. In addition, a dielectric layer of an outer build-up layer of a front-side build-up layer T is made of a PP material. Based on the combination architecture of the organic core PCB and the PP, a possibility of unidirectional bending and tilting of a build-up layer board can be avoided, to effectively improve stability and reliability of a use status.

Rear sides of the chip 2 and the electronic component 5 are aligned with a second surface 1B of the core PCB 1b, a front-side build-up layer T is disposed on a first surface A side of the core PCB 1c, and no rear-side build-up layer B is disposed. In this way, a heat conduction path on a rear side of the chip is short, and thermal conductivity can be maximized.

In this implementation solution, both a material of a dielectric layer 31 of a first front-side build-up layer 3 and an embedded material for filling gaps between components and between the components and an embedded slot of the core PCB are exposable and developable materials.

Other components and connection relationships of the embedded substrate 100k may be the same as those of the embedded substrate shown in FIG. 22. Details are not described herein again.

With reference to FIG. 25, the following briefly describes a fabrication process of the embedded substrate 100k described in FIG. 24.

Step S2501: Prepare a core PCB 1b.

Step S2502: Prepare for embedding and mounting, and attach adhesive tape to a second surface of the core PCB.

Step S2503: Mount a chip and an electronic component.

Step S2504: Perform press-fitting and filling.

An exposable and developable material is used as an embedded filling material 1-3 that forms a dielectric layer 31 of a first front-side build-up layer 3 while filling gaps between components and between the components and the embedded slot.

For the foregoing step S2501 and step S2502, refer to the procedures of step S901 and step S902 shown in FIG. 9. Alternatively, for the foregoing step S2501 and step S2502, refer to the procedures of step S1303 and step S1304 shown in FIG. 13.

Step S2505: Bond a carrier by using adhesive.

After the adhesive tape 1-2 is removed, bond the carrier (carrier) 1-4 to a rear side by using adhesive. In a specific implementation, pyrolytic adhesive or photolytic adhesive may be used to bond the carrier. For example, without constituting a limitation, the carrier may be an FR4, a BT core, a metal plate, or a glass plate.

Step S2506: Form a hole on a front side through an exposure and development process, form conduction structures, and form the first front-side build-up layer.

Based on the exposure and development process, a corresponding hole is formed on the dielectric layer 31 of the first front-side build-up layer 3, to construct a corresponding conduction structure. After a seed layer is formed, wall surfaces of holes are electroplated to form conductive blind vias, to construct corresponding conduction structures. In addition, the front side is electroplated to form surface copper, and a surface copper layer on the front side is patterned to form a line layer 32 of the first front-side build-up layer 3.

Step S2507: Form an outer layer of a front-side build-up layer T.

Step S2508: Form an outer solder mask layer 6, and process a surface of outer-layer metal.

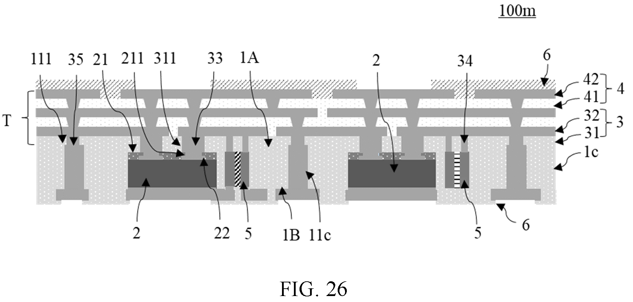

In the foregoing implementation solution, the core PCB serves as a core container. In another specific implementation, a filling material may alternatively be used to form a core container. FIG. 26 is a cross-sectional view of an architecture of still another embedded substrate according to an embodiment of this application. To clearly show a difference and a relationship between this implementation solution and the embodiments described in FIG. 22 and FIG. 24, components or structures with a same function are indicated by a same reference sign in the figures.

As shown in FIG. 26, a core container 1d of the embedded substrate 100m is a dielectric filling layer made of a dielectric filling material, and a chip 2 and an electronic component 5 are embedded in the core container 1d. That is, a framework structure without a core PCB is used. A process is simple, and manufacturing costs can be properly controlled. Conduction between a first surface 1A and a second surface 1B of the core container 1d is implemented by a copper pillar 11d, and the copper pillar 11d has high thermal conductivity and a good through-current capability.

A similarity to the embedded substrates described in FIG. 22 and FIG. 22 lies in: In this implementation solution, a single-sided build-up layer structure is also used. Rear sides of the chip 2 and the electronic component 5 are aligned with the second surface 1B of the core container 1d, a front-side build-up layer T is disposed on a first surface A side of the core container 1d, and no rear-side build-up layer B is disposed. In this way, a rear copper layer or a base of the chip 2 is directly exposed from the bottom, a heat conduction path on a rear side of the chip is short, and thermal conductivity can be maximized.

In this implementation solution, both a material of a dielectric layer 31 of a first front-side build-up layer 3 and an embedded material for filling gaps between components and between the components and an embedded slot of a core PCB are exposable and developable materials. In this way, a first conduction structure can be constructed based on an opening size on the chip side to a maximum extent, and the first conduction structure has a large through-current cross section, to effectively improve a through-current capability and achieve high thermal conductivity. In addition, when a requirement for a large through-current capability and high thermal conductivity on a front side of the chip is met, the dielectric layer of the first front-side build-up layer and an outer protective layer on the chip side are made of materials whose coefficients of thermal expansion tend to be close to each other, and both are made of organic materials. This can reduce bonding stress between a line layer and the front side of the chip, and reduce a risk of delamination.

Other components and connection relationships of the embedded substrate 100m may be the same as those of the embedded substrate shown in FIG. 22. Details are not described herein again.

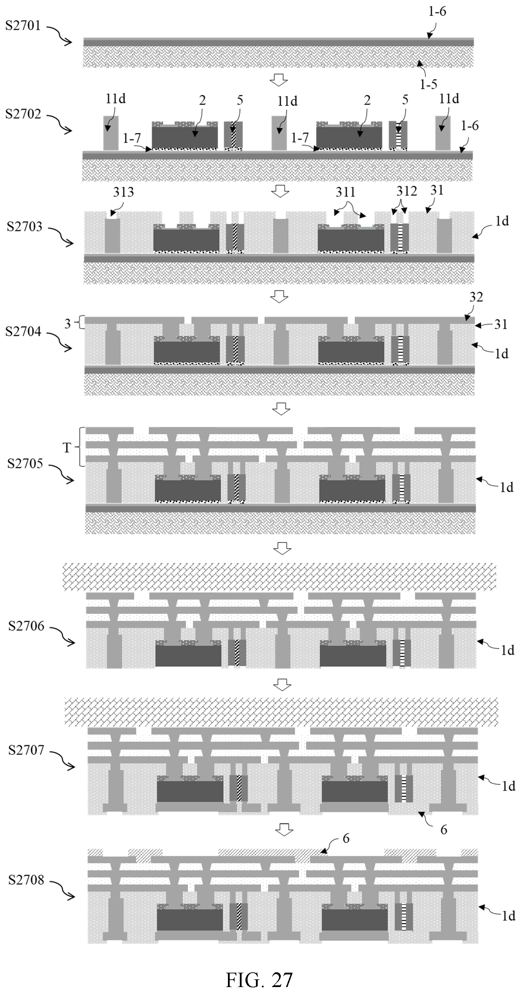

With reference to FIG. 27, the following briefly describes a fabrication process of the embedded substrate 100m described in FIG. 26.

Step S2701: Cover a first carrier 1-5 with a separable copper foil 1-6. For example, without constituting a limitation, the first carrier 1-5 may be an organic core PCB.

Step S2702: Process a copper pillar 11d on the copper foil 1-6, for example, but not limited to, forming the copper pillar 11d through film pressing, exposure, development, electroplating, and film stripping processes, apply temporary bonding adhesive 1-7 to the copper foil 1-6, and mount a chip 2 and an electronic component 5.

Step S2703: Press-fit a dielectric filling material, for example, but not limited to, press-fitting an exposable and developable material, to form a filling material layer of a core container 1d and a dielectric layer 31 of a first front-side build-up layer 3; and form a hole through an exposure and development process.

Specifically, a first hole 311 is formed in correspondence to a pad of the chip 2, a second hole 312 is formed in correspondence to a pin of the electronic component 5, and a third hole 313 is formed in correspondence to the copper pillar 11d. In a specific implementation, after holes are formed, components are electrically connected to interfaces or pins and are exposed from corresponding holes, to construct conduction structures.

Step S2704: Form conduction structures and surface copper of the first front-side build-up layer, and pattern a surface.

First, a seed layer is formed. Then wall surfaces of the first hole 311, the second hole 312, and the third hole 313 are electroplated to form conductive blind vias, to form a first conduction structure 33, a second conduction structure 34, and a third conduction structure 35 respectively.

In addition, a front side is electroplated to form surface copper, and the surface copper is patterned to form a line layer 32 of the first front-side build-up layer.

Step S2705: Form an outer layer of a front-side build-up layer T.

Step S2706: Bond a second carrier 1-8 to the front side, where for example, without constituting a limitation, the second carrier 1-8 may be made of an FR4, BT, stainless steel, or glass material, the second carrier 1-8 is bonded to the core container 1d through a temporary bonding material, and the temporary bonding material includes but is not limited to pyrolytic adhesive, photolytic adhesive, or photocurable adhesive; remove the first carrier, where a manner of removal includes but is not limited to pyrolysis, photolysis, or mechanical exfoliation; and finally, remove the copper foil 1-6 through etching, and remove the temporary bonding adhesive 1-7.

Step S2707: Pattern a rear-side interface to form a rear-side solder mask layer 6.

Step S2708: Remove the second carrier 1-8, where a manner of removal includes but is not limited to pyrolysis, photolysis, or mechanical exfoliation; and then form a front-side solder mask layer 6, for example, but not limited to, a liquid solder mask layer, a dry-film solder mask layer, a PID layer, or a PI layer.

Finally, surface metal processing is performed, including but not limited to the following process: ENEPIG (Electroless Nickel Electroless Palladium Immersion Gold, electroless nickel electroless palladium immersion gold), ENIG (Electroless Nickel/Immersion Gold, electroless nickel/immersion gold), OSP (Organic solderability preservative, organic solderability preservative layer), SOP, or the like.

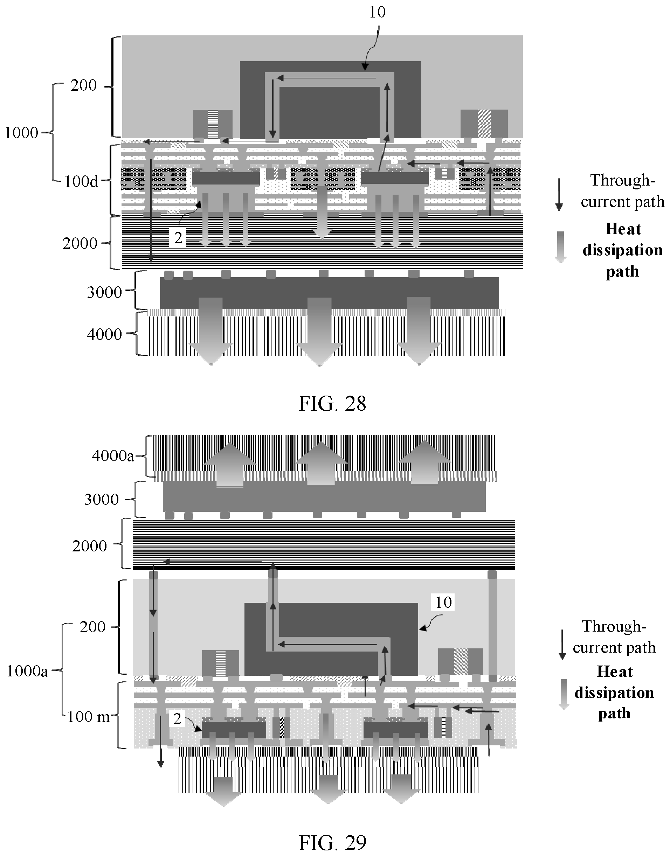

The embedded substrate architecture solutions described in the foregoing embodiments may be widely applied to packaging structures of different functional modules. During actual application, in a power module architecture scenario, the foregoing technical advantages are particularly outstanding. FIG. 28 is a diagram of an application scenario of a power supply apparatus according to an embodiment of this application.

As shown in FIG. 28, the power supply apparatus 1000 includes a chip 2, an inductor 10, and a plurality of electronic components. The chip 2 and a part of electronic components form a first package body by using the architecture of the embedded substrate 100d described in FIG. 12. The inductor 10 and another part of electronic components form a second package body 200, and the second package body 200 and the first package body (the embedded substrate 100d) are stacked. A rear side of the power supply apparatus 1000 is mounted to a side surface of a system board 2000, an XPU 3000 is mounted to another side surface of the system board 2000, and a heat dissipation component 4000 is attached to the XPU 3000.

In an in-use state, a large through-current capability and high thermal conductivity can be achieved. A through-current path is indicated by a thin line with an arrow in the figure, and a heat dissipation path is indicated by a bold line with an arrow in the figure.

In another implementation, the first package body may alternatively be formed by using an architecture of another embedded substrate in the foregoing descriptions. FIG. 29 is a diagram of an application scenario of a power supply apparatus according to an embodiment of this application.

In the power supply apparatus 1000a shown in FIG. 19, a chip 2 and a part of electronic components form a first package body by using the architecture of the embedded substrate 100m described in FIG. 26, an inductor 10 and another part of electronic components form a second package body 200, and the second package body 200 and the first package body (the embedded substrate 100m) are stacked. A front side of the power supply apparatus 1000a is mounted to a side surface of a system board 2000, an XPU 3000 is mounted to another side surface of the system board 2000, a first heat dissipation component 4000a is attached to the XPU 3000, and a second heat dissipation component 4000b is attached to a rear side of the power supply apparatus 1000a.

Similarly, a through-current path is indicated by a thin line with an arrow in the figure, and a heat dissipation path is indicated by a bold line with an arrow in the figure.

It should be understood that other functions of the power supply apparatus are not core inventive points of this application, and may be implemented by a person skilled in the art based on the conventional technology. Therefore, details are not described in this specification.

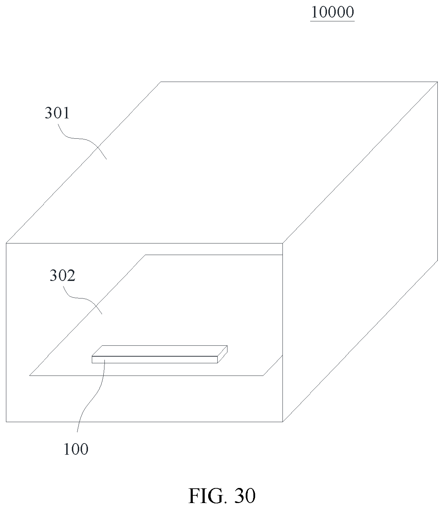

In addition to the foregoing embedded substrates, an implementation further provides an electronic device. FIG. 30 is a diagram of a structure of an electronic device according to an embodiment of this application.

As shown in FIG. 30, the electronic device 10000 includes a housing 301 and a main board 302 disposed in the housing 301. The embedded substrate 100 described in the foregoing embodiments is disposed on the main board 302. Based on a good large through-current capability and high thermal conductivity of the embedded substrate, the embedded substrate may be widely used in different high-density application scenarios.

In a specific implementation, the electronic device may be a server, a computer, a high-performance computing cluster, or a high-power, high-integration, and ultra-large-scale data center server, or the electronic device may be a switch, a router, an edge device, or the like. This is not limited in this embodiment of this application.

It should be understood that other functions of the electronic device are not core inventive points of this application, and may be implemented by a person skilled in the art based on the conventional technology. Therefore, details are not described in this specification.

The foregoing are merely example implementations of the present invention. It should be noted that a person of ordinary skill in the art may make several improvements and modifications without departing from the principle of the present invention, and the improvements and modifications shall be regarded as falling within the protection scope of the present invention.

## Claims

1. An embedded substrate, wherein the embedded substrate comprises a core container, a build-up layer, and a chip embedded in the core container, the core container comprises a first surface and a second surface, and a front side of the chip faces the first surface of the core container, wherein
an outer protective layer is disposed on an outer side of a pad of the chip, and the outer protective layer has an opening corresponding to the pad of the chip;
the build-up layer comprises a front-side build-up layer covering the first surface of the core container, the front-side build-up layer comprises a first front-side build-up layer, the first front-side build-up layer is bonded to the first surface of the core container and the front side of the chip, the first front-side build-up layer comprises a dielectric layer and a line layer that are stacked, a conduction structure electrically connected to the line layer of the first front-side build-up layer is disposed in the dielectric layer of the first front-side build-up layer, and the conduction structure comprises a first conduction structure electrically connected to the pad of the chip; and
the dielectric layer of the first front-side build-up layer is made of an exposable and developable material, a hole for constructing the conduction structure is formed through exposure and development, a hole for constructing the first conduction structure is a first hole, the opening of the outer protective layer has a first projection on the first surface, the first hole corresponding to the opening has a second projection on the first surface, and the second projection covers the first projection.

2. The embedded substrate according to claim 1, wherein the embedded substrate further comprises an electronic component embedded in the core container, the conduction structure further comprises a second conduction structure electrically connected to a pin of the electronic component, and a hole for constructing the second conduction structure is a second hole.

3. The embedded substrate according to claim 2, wherein a plurality of electronic components are disposed, and at least one of the plurality of electronic components is a capacitor or a resistor.

4. The embedded substrate according to any one of claims 1 to 3, wherein the embedded substrate further comprises a through-current structure disposed in the core container, the conduction structure further comprises a third conduction structure electrically connected to the through-current structure, and a hole for constructing the third conduction structure is a third hole.

5. The embedded substrate according to any one of claims 1 to 4, wherein the core container is a core PCB made of an organic material.

6. The embedded substrate according to claim 5, wherein the through-current structure in the core PCB is a PTH or a copper pillar that passes through a core PCB base, or the through-current structure in the core PCB is a hierarchical hole structure in the core PCB base.

7. The embedded substrate according to any one of claims 1 to 4, wherein the core container is a core PCB made of a glass material.

8. The embedded substrate according to claim 7, wherein the through-current structure in the core PCB is a TGV.

9. The embedded substrate according to any one of claims 5 to 8, wherein the chip and the electronic component embedded in the core PCB are aligned with a first surface of the core PCB, or are aligned with a second surface of the core PCB.

10. The embedded substrate according to any one of claims 5 to 9, wherein an embedded material at a periphery of the chip and the electronic component embedded in the core PCB is ABF, or an embedded material at a periphery of the chip and the electronic component embedded in the core PCB is an exposable and developable material.

11. The embedded substrate according to any one of claims 1 to 10, wherein the build-up layer further comprises a rear-side build-up layer covering the second surface of the core container.

12. The embedded substrate according to claim 11, wherein a heat conduction portion is disposed in the rear-side build-up layer, an inner end side of the heat conduction portion abuts against a rear side of the chip, and an outer end side of the heat conduction portion extends to a surface layer of the rear-side build-up layer.

13. The embedded substrate according to claim 12, wherein the heat conduction portion is a copper block, or blind vias or copper strips that are arranged in an array.

14. The embedded substrate according to claim 13, wherein the rear side of the chip has a rear copper layer, and the inner end side of the heat conduction portion abuts against the rear copper layer.

15. The embedded substrate according to any one of claims 11 to 14, wherein the rear-side build-up layer comprises a first rear-side build-up layer, the first rear-side build-up layer is bonded to the second surface of the core container, the first rear-side build-up layer comprises a dielectric layer and a line layer that are stacked, and a conduction structure electrically connected to the line layer of the first rear-side build-up layer is disposed in the dielectric layer of the first rear-side build-up layer.

16. The embedded substrate according to claim 15, wherein the dielectric layer of the first rear-side build-up layer is made of an exposable and developable material, and a hole for constructing the conduction structure is formed through exposure and development.

17. The embedded substrate according to claim 15, wherein the dielectric layer of the first rear-side build-up layer is made of a PP material.

18. The embedded substrate according to any one of claims 15 to 17, wherein the rear-side build-up layer comprises at least one second rear-side build-up layer, the second rear-side build-up layer is stacked on the first rear-side build-up layer, the second rear-side build-up layer comprises a dielectric layer and a line layer that are stacked, and the dielectric layer of the second rear-side build-up layer is made of ABF, PP, or an exposable and developable material.

19. The embedded substrate according to any one of claims 1 to 18, wherein the front-side build-up layer comprises at least one second front-side build-up layer, the second front-side build-up layer is sequentially stacked on the first front-side build-up layer, the second front-side build-up layer comprises a dielectric layer and a line layer that are stacked, and the dielectric layer of the second front-side build-up layer is made of ABF, PP, or an exposable and developable material.

20. The embedded substrate according to any one of claims 1 to 4, wherein the core container is a dielectric filling layer made of a dielectric filling material.

21. The embedded substrate according to claim 20, wherein the dielectric filling material is an exposable and developable material.

22. The embedded substrate according to claim 20 or 21, wherein a through-current structure in the dielectric filling layer is a copper pillar.

23. The embedded substrate according to any one of claims 20 to 22, wherein the chip and the electronic component embedded in the core PCB are aligned with a second surface of the dielectric filling layer.

24. A power supply apparatus, comprising a chip, an inductor, and a plurality of electronic components, wherein the chip and a part of the plurality of electronic components form a first package body by using the embedded substrate according to any one of claims 1 to 23, the inductor and another part of the plurality of electronic components form a second package body, and the second package body and the first package body are stacked.

25. An electronic device, comprising a system board and a power supply apparatus, wherein the power supply apparatus is disposed on the system board, and the power supply apparatus is the power supply apparatus according to claim 24.

26. An electronic device, comprising a main board and an embedded component, wherein the embedded component is disposed on the main board, and the embedded component is prepared by using the embedded substrate according to any one of claims 1 to 23.
